# EUROPEAN PATENT APPLICATION

(11) **EP 2 555 408 A1**
(43) Date of publication of application: **06.02.2013**
(21) Application number: 11765681.9
(22) Date of filing: 30.03.2011
(51) Int. Cl.: H02M 7/48

(54) **POWER CONVERSION DEVICE**

(30) Priority: 01.04.2010 JP 2010084785
(71) Applicant: Hitachi Automotive Systems, Ltd., Hitachinaka-shi Ibaraki 312-8503 (JP)
(72) Inventor: MAEDA, Ken, Hitachinaka-shi Ibaraki 312-8503 (JP); NAKAJIMA, Kenichiro, Hitachinaka-shi Ibaraki 312-8503 (JP); KASE, Masamichi, Hitachinaka-shi Ibaraki 312-8503 (JP)
(74) Representative: MERH-IP Matias Erny Reichl Hoffmann
(86) International application number: PCT/JP2011/058097
(87) International publication number: WO 2011/125781

(57) **Abstract**

A power conversion apparatus includes a smoothing capacitor module having a plurality of one and the other DC terminals arranged in a state of being laminated with each other, a flow channel forming body for forming a cooling medium flow channel that allows a cooling medium to flow along the capacitor module, and a plurality of power semiconductor modules each including a module case having a cooling surface, DC terminals projecting in one direction in a laminated state from the module case, and an AC terminal projecting in one direction from the module case. The power semiconductor modules are fixed to the flow channel forming body so that the cooling surface of the module case of the power semiconductor module is inserted into the cooling medium flow channel and comes into contact with the cooling medium flowing within the flow channel forming body, and the respective DC terminals in the laminated state of the capacitor module extend from the capacitor module toward the corresponding power semiconductor modules, the laminated DC terminal includes a connecting portion in the direction along the flow channel, the respective connecting portions in the direction along the flow channels of the DC terminals of the capacitor module are respectively connected to the DC terminals projecting from the power semiconductor module in the direction across the cooling medium flow channel.

## Description

### Technical Field

The present invention relates to a power conversion apparatus used for converting DC power to AC power or for converting AC power to DC power.

### Background Art

In general, a power conversion apparatus includes a smoothing capacitor module configured to receive DC power from a DC power supply, an inverter circuit configured to generate AC power upon reception of DC power from the capacitor module, and a control circuit configured to control the inverter circuit. The AC power is supplied, for example, to a motor, and the motor generates a rotation torque according to the supplied AC power. The motor generally has a function as a generator, and when a mechanical energy is supplied from the outside to the motor, the motor generates AC power on the basis of the supplied mechanical energy. The power conversion apparatus also has a function to convert AC power to DC power in many cases, and the AC power generated by the motor is converted into the DC power. Conversion from DC power to AC power or conversion from AC power to DC power is controlled by the control device. For example, when the motor is a synchronous electric motor, the above-described control relating to the power conversion may be performed by controlling the phase of the a rotating field generated by a stator with respect to a magnetic pile position of a rotor of the synchronous motor. An example of the power conversion apparatus is disclosed in JP-A-2009-2192170.

The power conversion apparatus is mounted on, for example, a motor vehicle, and generates AC power to be supplied to an electric motor configured to generate a traveling rotation torque upon reception of DC power from a secondary battery mounted on the motor vehicle. In order to generate a braking force at the time of regenerative braking operation of vehicle, the electric motor generates AC power on the basis of traveling energy, the generated AC power is converted into the DC power by the power conversion apparatus, is stored in the secondary battery, and is used as power for the traveling of the vehicle again.

### Citation List

### Patent Literature

PTL 1: JP-A-2009-219270

### Summary of Invention

### Technical Problem

The inverter circuit performs exchange between DC power and AC power by performing operations to conduct or disconnect the circuit. A spike voltage on the basis of inductance of the circuit is generated by the conducting or disconnecting operation of the circuit. When the voltage is high, lowering of reliability such as insulation breakdown may result. A reduction of the inductance at a connecting portion between the smoothing capacitor module and a power semiconductor module of the inverter circuit is not sufficient.

It is an object of the present invention is to provide a power conversion apparatus which is capable of reducing an inductance at a connecting portion between a smoothing capacitor module and a power semiconductor module of the inverter circuit.

### Solution to Problem

A power conversion apparatus according to a first mode of the present invention includes a smoothing capacitor module having a plurality of one and the other DC terminals arranged in a state of being laminated with each other, a flow channel forming body for forming a cooling medium flow channel that allows a cooling medium to flow along the capacitor module, and a plurality of power semiconductor modules each including a module case having a cooling surface, DC terminals projecting in one direction in a laminated state from the module case, and an AC terminal projecting in one direction from the module case, characterized in that the power semiconductor modules are fixed to the flow channel forming body so that the cooling surface of the module case of the power semiconductor module is inserted into the cooling medium flow channel of the flow channel forming body and comes into contact with the cooling medium flowing within the flow channel forming body, and the respective DC terminals in the laminated state of the capacitor module extend from the capacitor module toward the corresponding power semiconductor modules, the laminated DC terminal includes a connecting portion in the direction along the flow channel, the respective connecting portions in the direction along the flow channels of the DC terminals of the capacitor module are respectively connected to the DC terminals projecting from the power semiconductor module in the direction across the cooling medium flow channel.
On the basis of the power conversion apparatus according to the first mode, the second mode of the present invention is preferably the power conversion apparatus characterized in that the respective DC terminals in the laminated state of the capacitor module are respectively formed of wide conductors, and the DC terminals in the laminated state projecting from the module case of the power semiconductor modules are formed of wide conductors project from the module case in the direction opposite the cooling medium flow channel, wide surfaces of the wide conductors of the respective DC terminals of the capacitor module come into contact respectively with wide surfaces of the DC terminals formed of the wide conductors of the power semiconductor module, and the respective DC terminals of the capacitor module being in contact with each other over the wide surfaces and the DC terminals of the power semiconductor modules are connected at portions in the direction opposite the cooling medium flow channel by welding.
On the basis of the power conversion apparatus according to the first or second mode, a third mode of the present invention is preferably the power conversion apparatus characterized in that the DC terminals in the laminated state projecting from the module cases of the power semiconductor modules in the one direction which is a direction opposite the cooling medium flow channel are respectively formed of wide conductors that the wide surfaces face each other, and the respective connecting portions of the capacitor module are formed of wide conductors so that the wide surfaces face each other, the wide surfaces located respectively inside the connecting portions of the capacitor module in the laminated state are fixed by welding so as to come into contact with the wide surfaces located outside the respective DC terminals of the power semiconductor modules in the laminated state.
On the basis of the power conversion apparatus according to the third mode, a fourth mode of the present invention is preferably the power conversion apparatus characterized in that the capacitor module includes a capacitor case and a plurality of capacitor cells stored in the capacitor case, and the DC terminals of the capacitor module project from the capacitor case in the laminated state, and the DC terminals of the capacitor module has a shape in which at least one of the DC terminals returns back in the direction of flow of the cooling medium in a segment between a connecting portion with respect to the DC terminal of the power semiconductor module and the capacitor case and a connecting portion of the other DC terminal of the capacitor module is located inside the returning back shape of the one of the DC terminals.
On the basis of the power conversion apparatus according to the forth mode, a fifth mode of the present invention may be the power conversion apparatus characterized in that the DC terminals of the capacitor module has a shape in which the DC terminals respectively return back in the direction of flow of the cooling medium in a segment between a connecting portion with respect to the DC terminal of the power semiconductor module and the capacitor case and a connecting portion of the other DC terminal of the capacitor module is located inside the returning back shape of the one of the DC terminals.
On the basis of the power conversion apparatus according to any one of the first to fifth modes, a sixth mode according to the present invention is preferably the power conversion apparatus characterized in that the power semiconductor modules each include semiconductor chips configuring an upper and lower arms, and a conductor configured to connect the semiconductor chips of the upper arm and the lower arm in series, and the AC terminals of the respective power semiconductor modules are electrically connected to the conductor configured to connect the semiconductor chips of the upper arm and the lower arm in series in the interiors of the respective power semiconductor modules.
On the basis of the power conversion apparatus according to the sixth mode, the seventh mode of the present invention is preferably the power conversion apparatus characterized in that an AC bus-bar assembly provided with a plurality of AC bus-bars are arranged with respect to the capacitor module via a space, and the AC bus-bars are connected by welding to the AC terminals of the corresponding power semiconductor modules.
On the basis of the power conversion apparatus according to the seventh mode, an eighth mode of the invention is preferably the power conversion apparatus wherein a driver circuit configured to operate the respective power semiconductor modules is arranged at a position opposite the capacitor module with the AC bus-bar assembly interposed therebetween.
On the basis of the power conversion apparatus according to the sixth to eighth modes, a ninth mode of the present invention is preferably the power conversion apparatus characterized in that the capacitor module has a substantially rectangular shape, and a plurality of DC terminals in the laminated state are arranged along a long side of the capacitor module, and a power supply terminal configured to transfer DC power with the DC power supply is provided on a short side of the capacitor module.

A power conversion apparatus according to an embodiment of the present invention includes a smoothing capacitor module having a plurality of DC terminals arranged in a state of being laminated, a flow channel forming body for forming a cooling medium flow channel, and a plurality of power semiconductor modules each including DC terminals projecting from a module case having a cooling surface in a laminated state and an AC terminal projecting from the module case, wherein the power semiconductor modules are arranged along the cooling medium flow channel, the DC terminals of the capacitor module extend toward the corresponding power semiconductor modules, the DC terminals includes connecting portions in the direction along the flow channel, and the respective connecting portions of the capacitor module are respectively connected to the DC terminals projecting respectively from the power semiconductor modules.

### Advantageous Effects of Invention

According to the present invention, reduction of inductance of the connecting portions between the smoothing capacitor modules and the power semiconductor modules of the inverter circuit is achieved, so that improvement of reliability of the power conversion apparatus is achieved. Brief Description of Drawings

[Fig. 1] Fig. 1 is a system diagram illustrating a system of a hybrid motor vehicle to which a power conversion apparatus according to a first embodiment of the present invention is applied.
[Fig. 2] Fig. 2 is a circuit diagram illustrating a configuration of an electric circuit illustrated in Fig. 1.
[Fig. 3] Fig. 3 is an exploded perspective view for explaining a configuration of the power conversion apparatus.
[Fig. 4] Fig. 4 is a perspective view illustrating a state in which components are disassembled in order to explain the entire configuration of the power conversion apparatus.
[Fig. 5] Fig. 5 is a drawing viewing a flow channel forming body illustrated in Fig. 4 viewed from the bottom in order to explain the flow channel forming body.
[Fig. 6] Fig. 6(a) is a perspective view showing an appearance of a power semiconductor module, and Fig. 6(b) is a cross-sectional view of the power semiconductor module.
[Fig. 7] Fig. 7 (a) is an internal cross-sectional view of the power semiconductor module from which a module case, an insulative sheet, a first sealing resin, and a second sealing resin are removed for the sake of easy understanding, Fig. 7 (b) is a perspective view for explaining an internal configuration of the power semiconductor module.
[Fig. 8] Fig. 8 (a) is an exploded view for the sake of easy understanding of the configuration of Fig. 8(b), Fig. 8 (b) is a circuit drawing of the power semiconductor module.
[Fig. 9] Fig. 9 (a) is a circuit drawing for explaining an effect of reducing an inductance, Fig. 9(b) is an explanatory drawing for explaining an action of reducing the inductance.
[Fig. 10] Fig. 10 (a) is a perspective view of an auxiliary mold body, Fig 10 (b) is a transmissive image drawing of the auxiliary mold body.
[Fig. 11] Fig. 11 is an exploded perspective view for explaining an internal structure of a capacitor module.
[Fig. 12] Fig. 12 is an appearance perspective view illustrating a state in which the power semiconductor module, the capacitor module, and a bus-bar assembly assembled to the flow channel forming body.
[Fig. 13] Fig. 13 is an enlarged drawing of a portion A shown by a broken line in Fig. 12.
[Fig. 14] Fig. 14 is an exploded perspective view illustrating a relationship between the flow channel forming body to which the power semiconductor module and the capacitor module are assembled and the bus-bar assembly.
[Fig. 15] Fig. 15 is an appearance perspective view of the bus-bar assembly from which a holding member is removed.
[Fig. 16] Fig. 16 is an appearance perspective view of the flow channel formed boy to which the power semiconductor module, the capacitor module, the bus-bar assembly, and a power module for auxiliary equipment are assembled.
[Fig. 17] Fig. 17 is a perspective view of the power conversion apparatus from which a control circuit board and a metal base panel are separated for explanation.
[Fig. 18] Fig. 18 is a cross-sectional view viewing a cross section taken along a broken line B in Fig. 17 from the direction of an arrow C.
[Fig. 19] Fig. 19 is an explanatory drawing for explaining a connecting state between a DC terminal of the capacitor module and a DC terminal of the power semiconductor module.
[Fig. 20] Fig. 20 is an explanatory drawing for explaining another connecting state between the DC terminal of the capacitor module and the DC terminal of the power semiconductor module.
[Fig. 21] Fig. 21 is an explanatory drawing for explaining still another connecting state between the DC terminal of the capacitor module and the DC terminal of the power semiconductor module.
[Fig. 22] Fig. 22 is an explanatory drawing for explaining still another connecting state between the DC terminal of the capacitor module and the DC terminal of the power semiconductor module.
[Fig. 23] Fig. 23 is an explanatory drawing for explaining still another connecting state between the DC terminal of the capacitor module and the DC terminal of the power semiconductor module.
[Fig. 24] Fig. 24 is an explanatory drawing for explaining still another connecting state between the DC terminal of the capacitor module and the DC terminal of the power semiconductor module.
[Fig. 25] Fig. 25 is an explanatory drawing for explaining still another connecting state between the DC terminal of the capacitor module and the DC terminal of the power semiconductor module.
[Fig. 26] Fig. 26 is an explanatory drawing for explaining still another connecting state between the DC terminal of the capacitor module and the DC terminal of the power semiconductor module.

### Description of Embodiments

A power conversion apparatus according to embodiments to which the present invention is applied and a system using the apparatus described below solves various problems which are desired to be solved for commercialization. One of the various problems solved by these embodiments is a problem relating to a reduction of inductance described in the paragraph of Solution to Problem given above, and effects of the reduction of inductance and the improvement of reliability described in the paragraph of Advantageous Effects of Invention are achieved. In other words, the power conversion apparatus and the system using the power conversion apparatus described in detail below solve the various problems which are desired to be solved for commercialization, and there is a problem of downsizing described in Solution to Problem given above, and not only the effect of downsizing described in Advantageous Effects of Invention given above, various problems other than the above described problem are solved and various effects other than the above described effect are achieved. In addition, the problem relating to the reduction of the inductance described in Solution to Problem given above, and also a configuration to achieve the effects which contribute to achieve the effects relating the reduction of the inductance and the improvement of the reliability described in Advantageous Effects of Invention given above is solved not only by the configuration described in Solution to Problem, but also by other configurations, so that the above-described effects can be obtained. Some of representatives will be listed below. In addition, others will be described in the description given in embodiments.

Configuration 1 which achieves further reduction of inductance will be described below. It is a configuration in which power semiconductor modules are arranged along a cooling medium flow channels, DC terminals in a laminated state projecting from cases of the power semiconductor modules and connecting portions in the direction along the cooling medium flow channels of a DC terminal of a capacitor module are brought into contact with each other, and the DC terminals being in contact with each other are connected. In this structure, the DC terminals of the capacitor module in the laminated state can be extended to connecting positions with respect to the DC terminals of the power semiconductor modules. Therefore, reduction of inductance is enabled. Also, since the connecting portions of the DC terminals of the capacitor module are extended from the direction along the cooling medium flow channels toward the terminals of the power semiconductor modules, complication of the structure of the connecting portion is avoided.

In Configuration 1 described above, by arranging the DC terminals of the power semiconductor modules inside the DC terminals of the capacitor module in the laminated state, the DC terminals of the power semiconductor modules may be arranged close to each other and, in this structure, reduction of inductance is enabled.

Furthermore, in Configuration 1, the DC terminals of the capacitor module has a shape in which at least one of the DC terminals returns back in the direction of flow of the cooling medium in a segment between connecting portions with respect to the DC terminals of the power semiconductor modules and the capacitor case and connecting portions of the other DC terminals of the capacitor module are located inside the returning back shapes of the one of the DC terminals. In this structure, the reduction of inductance is achieved.

Furthermore, in Configuration 1, since the connecting portions between the DC terminals of the capacitor module and the DC terminals of the power semiconductor modules are located in the direction opposite the cooling medium flow channel, the welding device can be inserted into the connecting portions easily, and improvement of the productivity of the welding work is achieved. In addition, improvement of reliability of welded portions is also achieved.

Furthermore, in Configuration 1, AC bus-bars may be arranged on the DC terminals of the capacitor module and the DC terminals of the power semiconductor modules, downsizing or improvement of the productivity is enabled.

Configuration 2 for solving the problem that further downsizing is preferable will be described below. Configuration 2 is such that the cooling medium flow channels and the smoothing capacitor module are arranged in a housing, vertically elongated power semiconductor modules are also arranged along the cooling medium flow channels, DC bus-bars configured to allow DC current to flow from the capacitor module to the power semiconductor modules are arranged, AC bus-bars are arranged on the upper sides of the DC bus-bars in the vertical direction, and control signal lines configured to control the power semiconductor modules are arranged on the AC bus-bars. In this configuration, the entire configuration of the power conversion apparatus may be arranged orderly, and downsizing of the power conversion apparatus is enabled. Also, an effect to achieve reduction of the size in the lateral direction across the cooling medium flow channel, that is, in the lateral direction of the power conversion apparatus is obtained. The above-described effect is significant when the power semiconductor modules include a series circuit having upper and lower arms of an inverter integrated therein, but may also be obtained even when the power semiconductor modules having one of the upper and lower arms inserted therein is used. However, when the power semiconductor module having one arm inserted therein is used, since the inverter for the upper arm and the power semiconductor module for the lower arm are used separately, the bus-bar configuration for connecting these arms is increased.

In Configuration 2 described above, the DC bus-bars and the AC bus-bars are arranged at positions near the side portions in the housing of the power conversion apparatus, and the capacitor module may be arranged in parallel on the center side of the bus-bars, so that the upper portion of the capacitor module can be effectively used. For example, other circuits may be arranged in the upper portion of the capacitor module, and as the embodiment from example, a semiconductor module for auxiliary equipment for generating AC power for driving an electric motor for auxiliary equipment such as a compressor may be arranged in this portion. Accordingly, downsizing of the power conversion apparatus is realized. In addition, the distance of connection between the capacitor module and the power semiconductor module is shortened, and the effect is obtained in reduction of inductance. Furthermore, when electrically connecting by welding work, the space for using the welding device can be secured easily, and hence the productivity is improved.

Furthermore, in Configuration 2, with a configuration in which a flow channel forming body formed with the cooling medium flow channels along the outer shape of the capacitor module is provided, and the capacitor module is fixed to the flow channel forming body, the power semiconductor modules and the capacitor module can be cooled together by the cooling medium flow channels. In addition, since the DC bus-bars and the AC bus-bars can be arranged near the side portions, the other circuits arranged on the upper side of the capacitor module can be arranged near the flow channel forming body. The other circuits in addition to the power semiconductor modules and the capacitor module are efficiently cooled. The other circuits may be various components for constituting the circuit. In particular, as described above, by arranging the semiconductor module for auxiliary equipment in this portion as other circuits, the entire apparatus may further be downsized and the semiconductor module for auxiliary equipment may be cooled efficiently, which leads to improvement of the reliability.

Configuration 3 as another configuration for solving the problem that further downsizing is preferable will be described below. Configuration 3 is such that a plurality of the AC bus-bars for outputting the AC power from the power semiconductor module or for supplying the AC power generated by a motor to the power semiconductor module are formed of wide conductors, so that the respective AC bus-bars are arranged in a line so that narrow surfaces of the respective AC bus-bars extend along the vertical direction of the housing and the wide surfaces thereof face each other. This configuration has an effect that the volume occupied by the plurality of AC bus-bars may be reduced.

In addition to Configuration 3 described above, the plurality of AC bus-bars are configured to be integrated as an AC bus-bar assembly. The configuration is such that the AC bus-bar assembly includes a holding member having a fixing portion and the plurality of AC bus-bars are fixed to the holding member so that the plurality of AC bus-bars are integrated. In this configuration, the entire part is downsized. Furthermore, by fixing the fixing portion of the AC bus-bar assembly, the plurality of AC bus-bars can be fixed, so that improvement of the productivity is achieved. Furthermore, the probability of interference between the other circuits and an inner surface of the housing may be reduced, which leads to improvement of reliability.

In addition to Configuration 3 described above, by arranging the flow channels for allowing the cooling medium to flow along the side portions of the housing and arranging the AC bus-bar along the flow channel of the cooling medium, achievement of downsizing of the power conversion apparatus is further facilitated. Since the power semiconductor modules are arranged along the cooling medium flow channels, electric connection is also facilitated.

Configuration 4 as another configuration for solving the problem that further downsizing is preferable will be described below. Configuration 4 is such that a plurality of the AC bus-bars for outputting the AC power from the power semiconductor modules or for receiving the AC power generated by the motor by the power semiconductor modules are formed of wide conductors, so that the respective AC bus-bars are arranged along the cooling medium flow channels arranged respectively in the both side portions of the housing, and other circuits are arranged at positions near the center with respect to the AC bus-bars at the both side portions. As the other circuits, the semiconductor module for auxiliary equipment for generating AC power for driving the electric motor for auxiliary equipment such as a compressor as in the embodiment may be arranged. Accordingly, downsizing of the power conversion apparatus is realized. In addition to this effect, the other circuits such as the semiconductor module for auxiliary equipment can be fixed directly or close to the flow channel formation body which constitutes the cooling medium flow channel, and the other circuits such as the semiconductor module for auxiliary equipment in addition to the power semiconductor modules can be cooled efficiently.

Configuration 5 as another configuration for solving the problem that further downsizing is preferable will be described below. Configuration 5 is such that connecting positions of signal terminals projecting from the power semiconductor modules arranged along the cooling medium flow channels are provided at positions on one side with respect to the DC terminals or the AC terminals in the vertical direction, and a driver circuit is arranged at a position on one side in the vertical direction with respect to the capacitor module or the AC bus-bar in the vertical direction. In this configuration, the position to arrange the DC or AC bus-bars which allow a high current to flow and the position of wiring for supplying signals to the signal terminals may be divided into two in the vertical direction and hence the wiring may be arranged orderly. This leads to realization of downsizing of the power conversion apparatus. In addition, when connection of the DC or AC bus-bars allowing a high current to flow therethrough is performed by welding connecting process and connection of the signal terminals is performed by soldering connecting process, the welding process and the soldering process may be separated, which leads to improvement of the productivity.

Configuration 6 as another configuration for solving the problem that further downsizing is preferable will be described below. Configuration 6 is such that the power conversion apparatus is formed into a substantially cuboid structure, the cooling medium flow channels configured to allow the cooling medium to flow are arranged along longitudinal sides of the rectangular on the upper surface thereof, the power semiconductor modules are arranged along cooling medium flow channels, and furthermore, the AC bus-bars are formed of wide conductors and arranged in such a manner that the narrow surfaces of the respective AC conductors extend in the vertical direction, and the wide surfaces thereof extend along the cooling medium flow channels so as to face each other, the AC bus-bars extending along the cooling medium flow channels are aligned on the short sides of the substantially rectangular shape of the power conversion apparatus, and AC power is output from the short side. In this configuration, the space occupied by the AC bus-bars can be reduced, the arrangement relationship with other circuits is fixed, and further downsizing of the power conversion apparatus is enabled.

Configuration 7 for solving the problem relating to improvement of the productivity will be described below. Configuration 7 is such that the capacitor module and the power semiconductor modules are fixed to the cooling medium flow channel forming body for forming the cooling medium flow channels in the interior of the housing of the power conversion apparatus, and the AC bus-bar assembly is arranged further thereon. In this configuration, connection of the capacitor modules and the power semiconductor modules is easily achieved, and then connection between the power semiconductor modules and the AC bus-bar assembly is easily achieved. Accordingly, improvement of the productivity is achieved. In particular, since high current flows through the connecting portions between the capacitor module and the power semiconductor modules, electric connection is performed by welding in many cases. First of all, the capacitor module and the power semiconductor modules are connected by welding, and subsequently, the AC bus-bar assembly is fixed, so that the power semiconductor modules and the AC bus-bar assembly can be connected by welding. In the connection by welding, it is necessary to introduce the welding device to the welding portion and, in the structure described above, the welding device can be introduced to the welding portion. Also, by performing connection by the welding first, and then performing the connection by the soldering, workability is improved. The above-described structure not only contributes to the downsizing, but also improves the productivity when electrical connection is performed by the welding process. In addition, by using the welding process for the electric connection between the capacitor module and the power semiconductor modules and the electric connection between the power semiconductor modules and the AC bus-bar assembly, it is no longer necessary to secure surface area for screwing in terminal portions of the power semiconductor modules, so that the power semiconductor module can be downsized, which leads to downsizing of the power conversion apparatus.

Another configuration 8 for solving the problem relating to improvement of the productivity will be described below. Configuration 8 is basically the same as the configuration described in Configuration 4, and is such that the connecting portion of signal terminals projecting from the power semiconductor modules arranged along the cooling medium flow channels are provided at positions on one side with respect to the connecting portions of the DC terminals or the AC terminals in the vertical direction, and a driver circuit is arranged at a position on one side in the vertical direction with respect to the capacitor module or the AC bus-bar in the vertical direction. In this configuration, by arranging the position where the bus-bar for allowing a high current to flow is arranged and the position of the wiring that supplies signal to the signal terminal separately in the vertical direction, assembly in sequence in the vertical direction is possible and, furthermore, the connecting work can be performed in sequence in the vertical direction. Accordingly, improvement of the productivity is achieved.

Furthermore, in Configuration 8 described above, by performing the electric connection relating to the bus-bars which allows a high current to flow therethrough by the welding connection, and performing the connection of the wiring relating to the signal terminals by the soldering connection, the welding process and the soldering process are separated so that the welding process of the DC bus-bars and the welding process of the AC bus-bars can be performed closely. Accordingly, improvement of the productivity is achieved.

Configuration 9 for solving the problem relating to improvement of the reliability will be described below. Configuration 9 is a structure such that the flow channel forming body for forming the cooling medium flow channels for allowing the cooling medium to flow is arranged in the interior of the metallic housing, the AC bus-bars for allowing the AC current to flow are fixed to the flow channel forming body, and current sensors for detecting an electric current flowing through the AC bus-bars are fixed to the bus-bars. By arranging the current sensor on the bus-bars fixed to the flow channel forming body, the AC bus-bars are cooled via the flow channel forming body cooled by the cooling medium, the temperature rise of the AC bus-bars due to heat transferred from the motor-side, and the temperature rise of the current sensor may be inhibited.

For example, when fixing the power conversion apparatus to a member which may become a high temperature as a transmission in the vehicle, heat is transferred via the housing. The AC bus-bars for supplying AC power to the motor, formed of copper as a material, are suitable thermal conductors. Therefore, heat of the motor is transferred via the AC bus-bars, and the temperature of the current sensor may be increased. In Configuration 9, the AC bus-bars are fixed to the flow channel forming body for forming the cooling medium flow channels, and the current sensors are fixed to the AC bus-bars, so that the temperature rise of the current sensors is inhibited and improvement of the reliability is achieved.

Another configuration 10 for solving the problem relating to improvement of reliability will be described below. On the basis of configuration 9 described above, configuration 10 is such that AC bus-bar assemblies having a fixing member and a holding member are provided, the AC bus-bars are held and fixed by the holding member of the AC bus-bar assembly. The configuration is such that the AC bus-bar assembly is fixed to the flow channel forming body by a fixing device of the AC bus-bar assembly. The AC bus-bar assembly itself is fixed to the flow channel forming body by the fixing member.

In this configuration, assembly of the AC bus-bar assembly is facilitated, and the AC bus-bar assembly may be cooled by the flow channel forming body. The AC bus-bars may be cooled efficiently. Since the temperature rise of the current sensors can be inhibited, improvements of the reliability of the current sensors and reliability of the entire power conversion apparatus are achieved. The current sensor has a temperature characteristic vulnerable to high temperatures, and thermal resistance of the current sensors is an important problem to be solved.

Another configuration 11 for solving the problem relating to improvement of reliability will be described below. Configuration 11 is such that in addition to the cooling medium flow channels for cooling the power semiconductor modules by the flow of the cooling medium, a configuration to cool by outer peripheral surfaces of the cooling medium flow channels is provided and circuits which are wanted to be cooled are arranged on the outer peripheral surfaces. More specifically, the power semiconductor modules is inserted into the cooling medium flow channel for cooling by the flow of the cooling medium, and the circuit which is wanted to cool is brought into tight contact with the peripheral surfaces for being cooled by the outer peripheral surfaces. Examples of the circuits which is wanted to be cooled include a semiconductor module for auxiliary equipment for generating AC power to be supplied to the vehicle-mounted electric motor for auxiliary equipment such as a vehicle-mounted compressor as described in the embodiment, and the semiconductor module for auxiliary equipment is fixed to the outer peripheral surface for cooling.

In the embodiment described below, the flow channel forming body for forming the cooling medium flow channels is formed with a space for storing water as the cooling medium, and the semiconductor module for auxiliary equipment is arranged on the outer peripheral surface of the space for storing water, which is part of the outer peripheral surface of the flow channel forming body. In this configuration, the power semiconductor modules are cooled and the semiconductor module for auxiliary equipment can be efficiently cooled.

In addition to Configuration 10, by forming a depression for storing the smoothing capacitor module in the flow channel forming body, and fixing the capacitor module to the flow channel forming body, the power semiconductor module, the semiconductor module for auxiliary equipment, and the capacitor module can be cooled efficiently, and may be arranged compactly, so that further downsizing and efficient cooling of the power conversion apparatus are both achieved. Furthermore, since these members are fixed to the flow channel forming body, superior assembleability of the power conversion apparatus is also achieved.

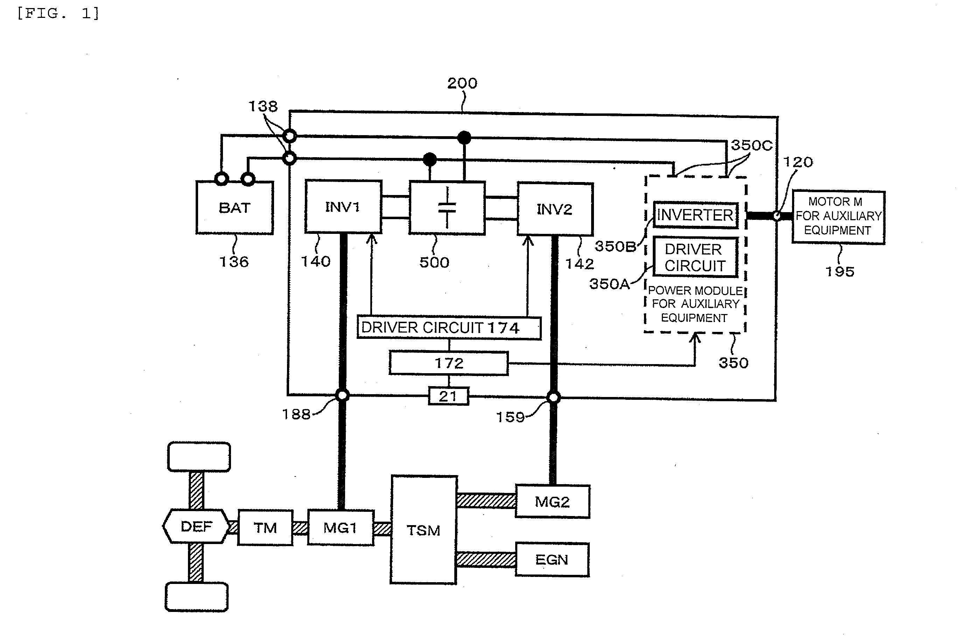

Referring now to the drawings, an embodiment of the present invention will be described by using the drawings. Fig. 1 is a system diagram in which the power conversion apparatus according to the present invention is applied to so-called hybrid motor vehicles which travel using both of an engine and a motor. The power conversion apparatus according to the present invention may be applied not only to the hybrid motor vehicles, but also to so-called electric motor vehicles which travel only using a motor, and may be used as a power conversion apparatus for driving the motor used for general industrial machines. However, as described above or below, especially when the power conversion apparatus according to the present invention is applied to the hybrid motor vehicles or electric motor vehicles described above, superior effects are obtained in terms of downsizing, in terms of reliability, and in other various terms. The power conversion apparatus applied to the hybrid motor vehicles has substantially the same configuration as the power conversion apparatus applied to the electric motor vehicles, and the power conversion apparatus applied to the hybrid motor vehicles will be described as a representative.

Fig. 1 is a drawing showing a control block of a hybrid motor vehicle (hereinafter, referred to as "HEV"). An engine EGN, a motor generator MG1, and a motor generator MG2 generate a traveling torque for the vehicle. The motor generator MG1 and the motor generator MG2 have functions of not only generating a rotation torque, but also of converting a mechanical energy applied from the outside to the motor generator MG1 or the motor generator MG2 to electric power.

The motor generator MG1 or MG2 is, for example, a synchronous machine or an induction machine and, as described above, operates as a motor or as a generator depending on the operating method. When the motor generator MG1 or MG2 is mounted on the motor vehicle, it is desirable to obtain a high output with small size, and a permanent magnet type synchronous electric motor using a magnet such as neodymium or the like is suitable. The permanent magnet type synchronous electric motor generates less heat from a rotor in comparison with an induction motor and hence is superior to be used for motor vehicles in this light as well.

Output torques on an output side of the engine EGN and of the motor generator MG2 are transmitted to the motor generator MG1 via a power transfer mechanism TSM, and a rotation torque from the power transfer mechanism TSM or the rotation torque generated by the motor generator MG1 is transmitted to wheels via a transmission TM and a differential gear DEF. On the other hand, at the time of regenerative braking, the rotation torque is transmitted to the motor generator MG1 from the wheels and AC power is generated on the basis of the supplied rotation torque. The generated AC power is converted to DC power by a power conversion apparatus 200 as described later, charges a battery 136 for high voltages, and the charged power is used as traveling energy again. When the charged power of the battery 136 for high voltages is reduced, rotation energy generated by the engine EGN is converted into AC power by the motor generator MG2, then the AC power is converted to the DC power by the power conversion apparatus 200, whereby charging the battery 136. Transmission of the mechanical energy from the engine EGN to the motor generator MG2 is performed by the power transfer mechanism TSM.

Subsequently, the power conversion apparatus 200 will be described. Inverter circuits 140 and 142 are electrically connected via the battery 136 and a DC connector 138, and a transfer of power is performed between the battery 136 and the inverter circuit 140 or 142 with respect to each other. When causing the motor generator MG1 to operate as a motor, the inverter circuit 140 generates AC power on the basis of DC power supplied from the battery 136 via the DC connector 138, and supplies the same to the motor generator MG1 via an AC terminal 188. A configuration composed of the motor generator MG1 and the inverter circuit 140 operates as a first motor generating unit. In the same manner, when causing the motor generator MG2 to operate as a motor, the inverter circuit 142 generates AC power on the basis of DC power supplied from the battery 136 via the DC connector 138, and supplies the same to the motor generator MG2 via an AC terminal 159. A configuration composed of the motor generator MG2 and the inverter circuit 142 operates as a second motor generating unit. The first motor generating unit and the second motor generating unit may be operated both as motors or generators according to the state of operation, or may be operated differently depending on the state of operation. It is also possible to stop one of those and not to operate. In this embodiment, the first power generating unit is operated as a power unit by the power of the battery 136, driving of the vehicle may be achieved only by the power of the motor generator MG1. Furthermore, in this embodiment, charging of the battery 136 is achieved by causing the first motor generating unit or the second motor generating unit to operate and generate power as the power generating unit by power of the engine EGN or the power of the wheels.

The battery 136 is used as a power supply for driving a motor 195 for auxiliary equipment. The motor for auxiliary equipment is a motor configured to drive a compressor of an air conditioner or a motor configured to drive a hydraulic pump for control. DC power is supplied to a power module 350 for auxiliary equipment from the battery 136, the power module 350 for auxiliary equipment generates AC power and supplies the same to the motor 195 for auxiliary equipment via the AC terminal 120. The power module 350 for auxiliary equipment basically has the same circuit configuration and function as the inverter circuits 140 and 142, and controls the phase, the frequency, and power of AC power to be supplied to the motor 195 for auxiliary equipment. Since the capacity of the motor 195 for auxiliary equipment is smaller than the capacities of the motor generator MG1 or MG2, the maximum conversion power of the power module 350 for auxiliary equipment is smaller than the inverter circuit 140 or 142. However, as described above, the basic configuration and the basic operation of the power module 350 for auxiliary equipment are substantially the same as the inverter circuits 140 and 142. The power conversion apparatus 200 includes a capacitor module 500 for smoothing DC power supplied to the inverter circuit 140, the inverter circuit 142, and an inverter circuit 350B.

The power conversion apparatus 200 includes a communication connector 21 configured to receive commands from a high-order control device or transmit data indicating the state to the high-order control device. A control circuit 172 calculates amounts of control of the motor generator MG1, the motor generator MG2 or the motor 195 for auxiliary equipment on the basis of a command from the connector 21, and calculates whether to be operated as a motor or a generator, generates control pulses depending on the result of calculation, and supplies the control pulse to a driver circuit 174 or a driver circuit 350A of the power module 350 for auxiliary equipment. The power module 350 for auxiliary equipment may have a specific control circuit. In this case, the specific control circuit generates the control pulses on the basis of the command from the connector 21, and supplies the same to the driver circuit 350A of power module 350 for auxiliary equipment. The driver circuit 174 generates drive pulses for controlling the inverter circuit 140 and the inverter circuit 142 on the basis of the control pulse. Also, a driver circuit 350A generates a control pulse for driving the inverter circuit 350B of the power module 350 for auxiliary equipment.

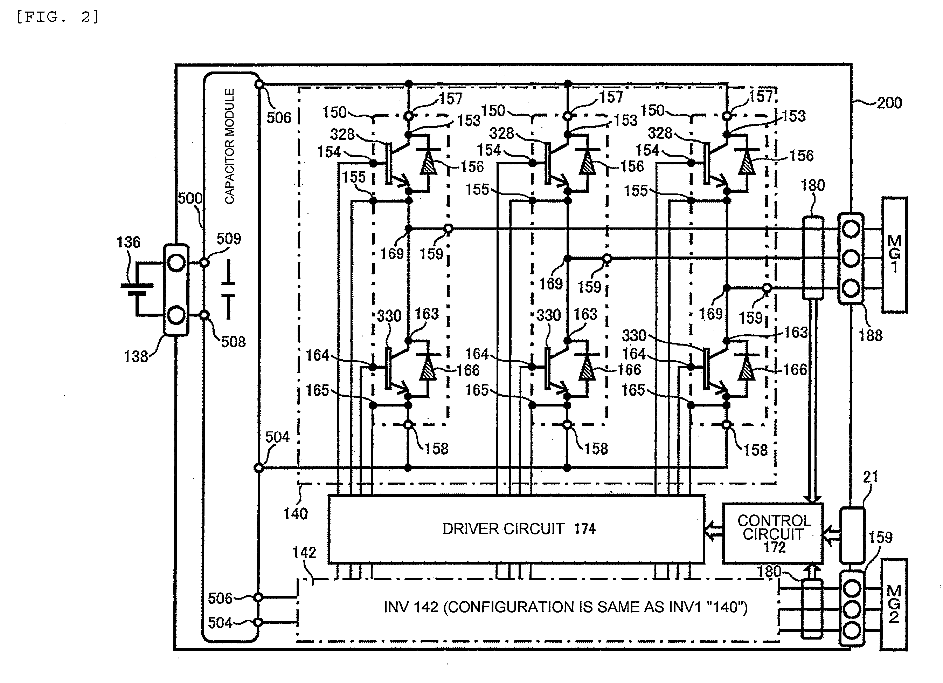

Subsequently, configurations of electric circuits of the inverter circuit 140 or the inverter circuit 142 will be described with reference to Fig. 2. Since the configuration of the circuit configuration of the inverter 350 of the power module 350 for auxiliary equipment illustrated in Fig. 1 is basically similar to the circuit configuration of the inverter circuit 140, detailed description of the circuit configuration of the inverter 350B in Fig. 2 is omitted and the inverter circuit 140 is described as a representative description. However, since the output power of the power module 350 for auxiliary equipment is small, semiconductor chips configuring an upper arm and a lower arm of respective phases described later or a circuit configured to connect the chips are arranged intensively in the power module 350 for auxiliary equipment.

In addition, since the inverter circuit 140 and the inverter circuit 142 are very similar in the circuit configuration and the operation, the inverter circuit 140 will be described as a representative.

An insulating gate type bipolar transistor is used as a semiconductor element described later, and is abbreviated as IGBT hereinafter. The inverter circuit 140 is provided with upper and lower arm series circuits 150 for upper and lower arms each including an IGBT 328 and a diode 156 configured to operate as the upper arm and an IGBT 330 and a diode 166 configured to operate as the lower arm corresponding to three phases including a U-phase, a V-phase, and a W-phase of AC power to be output. These three phases in this embodiment correspond to respective windings of the three phases of an armature winding of the motor generator MG1. The respective upper and lower arm series circuits 150 for three phases are configured to output AC current from intermediate electrodes 169, which are intermediate points of the series circuits, and the AC current is connected to AC bus-bar 802 or 804 described later which is AC power lines to the motor generator MG1 through the AC terminal 159 and the AC connector 188.

A collector electrode 153 of the IGBT 328 of the upper arm is electrically connected to positive-side capacitor terminal 506 of the capacitor module 500 via a positive terminal 157, and an emitter electrode of the IGBT 330 of the lower arm is electrically connected to a negative-side capacitor terminal 504 of the capacitor module 500 via a negative terminal 158, respectively.

As described above, the control circuit 172 receives a control command from the high-order control device via the connector 21, generates the control pulse as a control signal for controlling the IGBTs 328 and the IGBTs 330 which constitute the upper arm and the lower arm of the series circuits 150 of the respective phases which constitutes the inverter circuit 140 based on the control command, and supplies the control pulses to the driver circuit 174. The driver circuit 174 supplies the drive pulses for controlling the IGBTs 328 and the IGBTs 330 which constitute the upper arms or the lower arms of the series circuits 150 of the respective phases on the basis of the above-described control pulse. The IGBTs 328 and the IGBTs 330 perform conducting or disconnecting operation on the basis of the drive pulses from the driver circuit 174, convert DC power supplied from the battery 136 to three phase AC power, and the converted power is supplied to the motor generator MG1.

The IGBTs 328 each include the collector electrode 153, a signal emitter electrode 155 and a gate electrode 154. The IGBT 330 includes a collector electrode 163, a signal emitter electrode 165 and a gate electrode 164. The diode 156 is electrically connected between the collector electrode 153 and the emitter electrode. The diode 166 is electrically connected between the collector electrode 163 and the emitter electrode. As a switching power semiconductor element, a metallic oxide semiconductor type field-effect transistor (hereinafter, abbreviated as MOSFET) may be used. In this case, the diode 156 and the diode 166 are not necessary. As the switching power semiconductor element, the IGBT is suitable for a case where DC voltage is relatively high, and MOSFET is suitable for a case where the DC voltage is relatively low.

The capacitor module 500 includes the plurality of positive-side capacitor terminals 506, the plurality of negative-side capacitor terminals 504, a positive-side power supply terminal 509 and a negative-side power supply terminal 508. High voltage DC power from the battery 136 is supplied to the positive-side power supply terminal 509 or the negative side power supply terminal 508 via the DC connector 138, and is supplied from the plurality of positive-side capacitor terminals 506 or the plurality of negative-side capacitor terminals 504 of the capacitor module 500 to the inverter circuit 140, the inverter circuit 142, and the power module 350 for auxiliary equipment. In contrast, DC power converted from AC power by the inverter circuit 140 or the inverter circuit 142 is supplied from the positive-side capacitor terminals 506 or the negative-side capacitor terminal 504 to the capacitor module 500, is supplied from the positive-side power supply terminal 509 and the negative-side power supply terminal 508 to the battery 136 via the DC connector 138, and is accumulated in the battery 136.

The control circuit 172 is provided with a microcomputer configured to compute switching timings of the IGBTs 328 and the IGBTs 330. Input information to the microcomputer includes a target torque value requested to the motor generator MG1, a current value supplied from the upper and lower arm series circuits 150 to the motor generator MG1 and a polar position of the rotor of the motor generator MG1. The target torque value is based upon a command signal output from the high-order control device, not shown. The current value is detected on the basis of a detection signal from current sensors 180. The polar position is detected on the basis of the detection signal output from a rotation magnetic pole sensor (not shown) such as a resolver provided on the motor generator MG1. In this embodiment, although a case where the current sensors 180 detect the current value of three phases is exemplified, it is also possible to detect the current value of two phases and obtain currents of three phases by computation.

The microcomputer in the control circuit 172 computes current command values of d, q axes of the motor generator MG1 on the basis of the target torque value, computes voltage command values of the d, q axes on the basis of the difference between the computed current command values of the d, q axes and the detected current values of the d, q axes, and converts the computed voltage command values of the d, q axes to the voltage command values of the U-phase, the V-phase, and the W-phase on the basis of the detected polar position. Then, the microcomputer generates a pulsed modulated wave on the basis of the comparison between a basic wave (sinusoidal wave) and a carrier wave (triangle wave) based on the voltage command values of the U-phase, the V-phase and the W-phase, and outputs the generated modulated wave to the driver circuit 174 as a PWM (pulse width modulated) signal. When driving the lower arm, the driver circuit 174 outputs a drive signal obtained by amplifying the PWM signal to the gate electrode of the IGBT 330 of the corresponding lower arm. Also, when driving the upper arm, the driver circuit 174 shifts a level of the reference potential of the PWM signal to a level of the reference potential of the upper arm and then amplifies the PWM signal, and outputs the amplified signals as the drive signal to the respective gate electrodes of the corresponding IGBTs 328 of the upper arms.

A control unit 170 protects the upper and lower arm series circuits 150 by performing abnormal detection (excessive currents, excessive voltages, excessive temperatures). Therefore, sensing information is input to the control circuit 172. For example, information of current flowing to the emitter electrodes of the respective IGBTs 328 and the IGBTs 330 is input from the signal emitter electrodes 155 and the signal emitter electrodes 165 of the respective arms to corresponding drive units (ICs). Accordingly, the respective drive units (ICs) perform excessive current detection, and if the excessive current is detected, stops a switching operation of the corresponding IGBTs 328 and the IGBTs 330, and protects the corresponding IGBTs 328 and the IGBTs 330 from the excessive current. Information on the temperatures of the upper and lower arm series circuits 150 is input to the microcomputer from temperature sensors (not shown) provided in the upper and lower arm series circuits 150. Information on the voltages on the DC positive side of the upper and lower arm series circuits 150 is input to the microcomputer. The microcomputer performs the excessive temperature detection and the excessive voltage detection on the basis of the above-described items of information, and if the excessive temperature or the excessive voltage is detected, stops the switching operation of all the IGBTs 328 and the IGBTs 330.

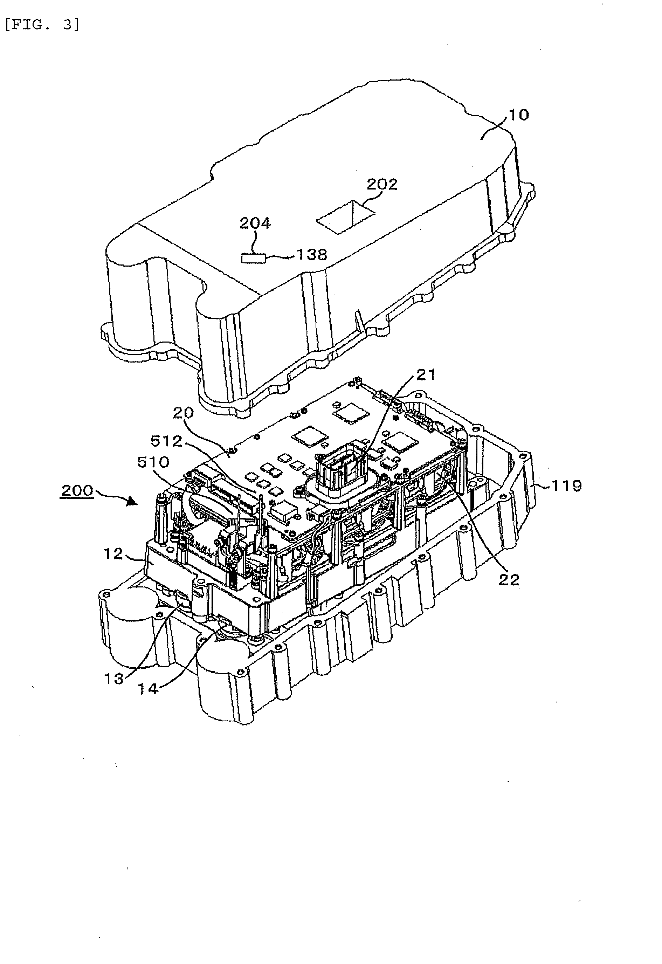

Fig. 3 shows an exploded perspective view of the power conversion apparatus 200 as an embodiment of the present invention. The power conversion apparatus 200 includes a housing 10 having an aluminum-made bottom for storing circuit components of the power conversion apparatus 200 fixed to the transmission TM and a lid 8. The power conversion apparatus 200 has a substantially rectangular shaped bottom surface and an upper surface and hence allows easy mounting on the vehicle, and provides an effect of easy-to-produce. A flow channel forming body 12 holds a power semiconductor module 300 described later and the capacitor module 500, and is configured to cool these modules by a cooling medium. The flow channel forming body 12 is fixed to the housing 10, and is provided with an inlet port piping 13 and an outlet port piping 14 on the bottom portion of the housing 10. Water as the cooling medium flows from the inlet port piping 13 into the flow channel forming body 12, and flows out from the outlet port piping 14 after having used for cooling.

The lid 8 stores the circuit components which constitute the power conversion apparatus 200, and is fixed to the housing 10. A control circuit board 20 on which the control circuit 172 is mounted is arranged on an upper portion inside the lid 8. The lid 8 is provided with a first opening 202 and a second opening 204 communicating with the outside, so that the connector 21 is connected to external control devices via the first opening 202 and signal transmission is performed between the control circuit 172 provided on the control circuit board 20 and the external control device such as the high-order control device. The DC power of a low voltage which operates the control circuit in the power conversion apparatus 200 is supplied from the connector 21. The second opening 204 is provided with the DC connector 138 for transferring DC power with respect to the battery 136, and a negative side power line 510 and a positive side power line 512 configured to supply high-voltage DC power to the interior of the power conversion apparatus 200 are electrically connected to the DC connector 138 and the capacitor module 500 configured to transfer the DC power with respect to the battery 136.

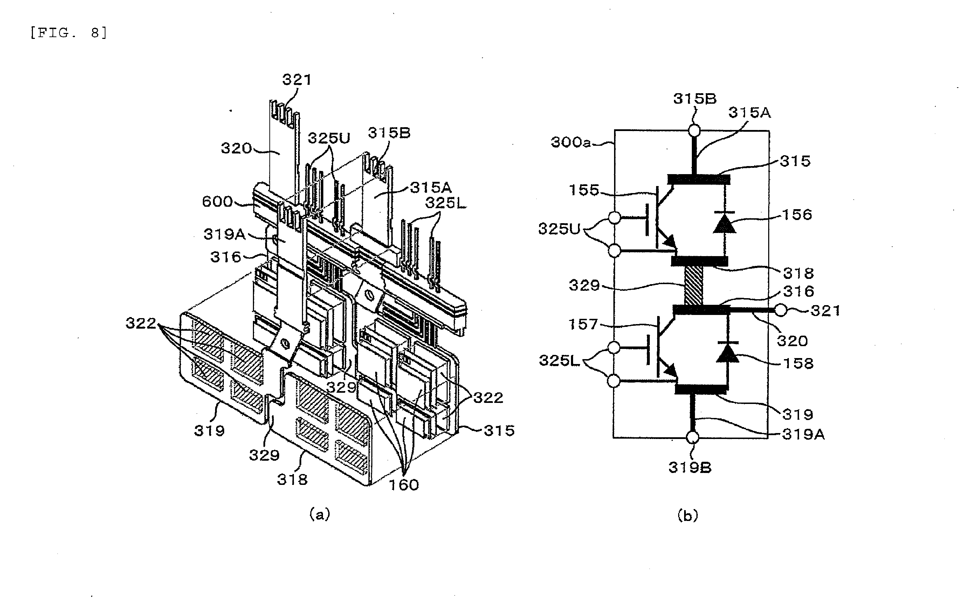

The connector 21, the negative side power line 510 and the positive side power line 512 extend toward the bottom surface of the lid 8, the connector 21 projects from the first opening 202, and distal end portions of the negative side power line 510 and the positive side power line 512 project from the second opening 204 to constitute the terminals of the DC connector 138. Fig. 8 is provided with seal members (not shown) on an inner wall thereof around the first opening 202 and the second opening 204. Directions of a fitting surface of the terminals such as the connector 21 and the like vary depending on the type of the vehicles. However, when an attempt is made to mount on a small vehicle, it is preferable to expose the fitting surface so as to face upward in terms of limitation of the space in an engine room and assemblability. In particular, as in the embodiment, when the power conversion apparatus 200 is arranged upward of the transmission TM, the workability is improved by causing the fitting surface to project toward the side opposite from the side where the transmission TM is arranged. The connector 21 is needed to be sealed from an atmosphere on the outside. However, with the configuration in which the lid 8 is assembled to the connector 21 from the upward direction, when the lid 8 is assembled to the housing 10, the seal member which comes into contact with the lid 8 can press the connector 21, whereby air-tightness is improved.

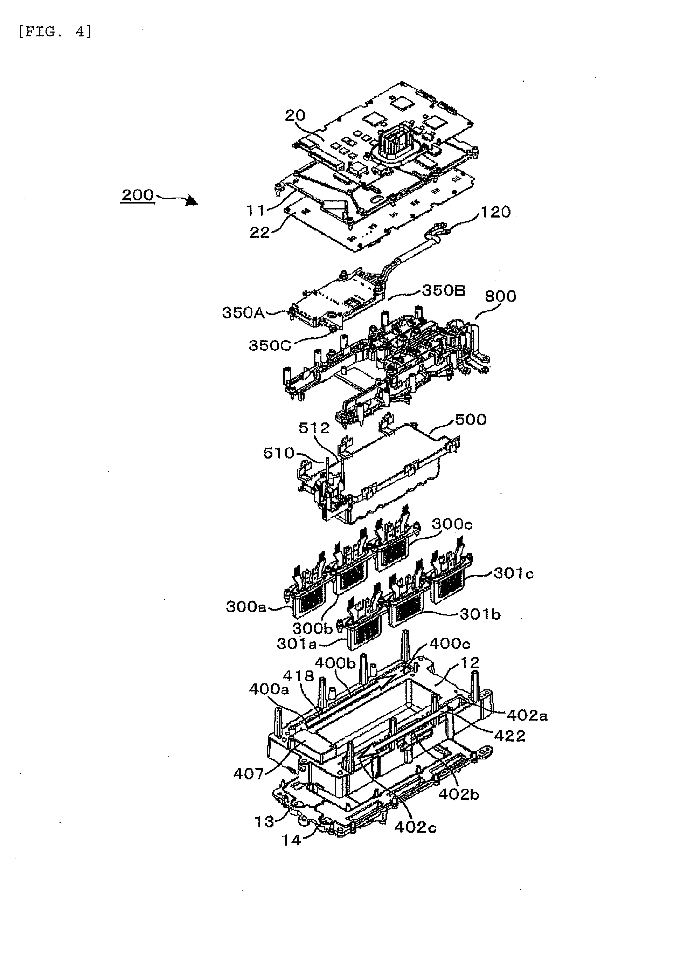

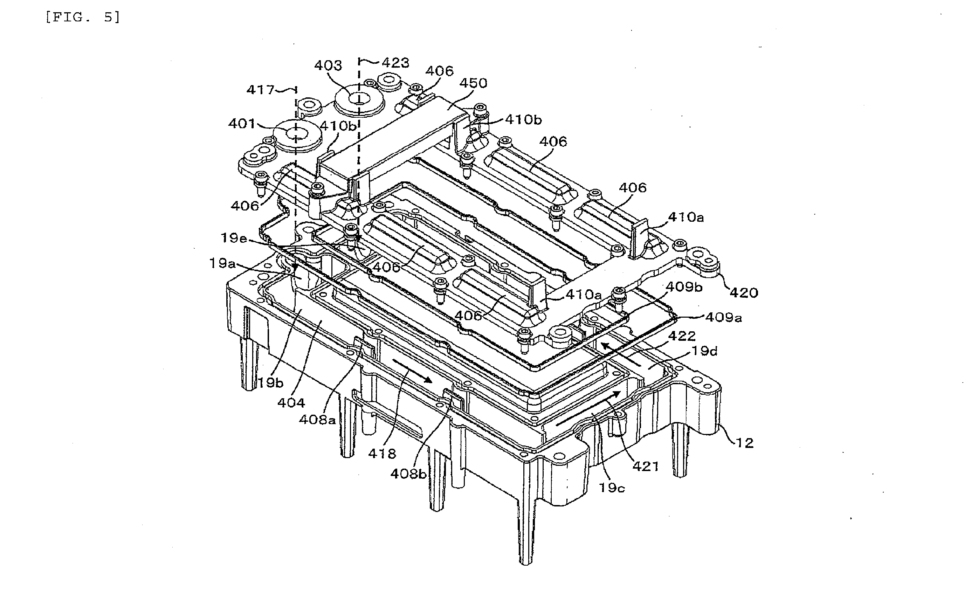

Fig. 4 is a perspective view illustrating a state in which components are disassembled for the sake of easy understanding of a configuration to be stored in the interior of the housing 10 of the power conversion apparatus 200. The flow channel forming body 12 is formed with cooling medium flow channels 19 illustrated in Fig. 5 so as to extend along both sides thereof. Formed on an upper surface of one of the cooling medium flow channels 19 are openings 400a to 400c along a flowing direction 418 of the cooling medium, and formed on an upper surface of the other one of the cooling medium flow channels 19 are openings 402a to 402c along a flowing direction 422 of the cooling medium. The openings 400a to 400c are covered with inserted power semiconductor modules 300a to 300c and the openings 402a to 402c are covered with inserted power semiconductor modules 301a to 301c.

Formed between the one and the other flow channels formed on the flow channel forming body 12 is a storage space 405 for storing the capacitor module 500, and the capacitor module 500 is stored in the storage space 405, so that the capacitor module 500 is cooled by the cooling medium flowing in the cooling medium flow channels 19. The capacitor module 500 is interposed between the cooling medium flow channel 19 for forming the flowing direction 418 of the cooling medium and the cooling medium flow channel 19 for forming the flowing direction 422 of the cooling medium, and hence efficient cooling is achieved. Since the flow channels to allow the cooling medium to be flowed are formed along outer side surfaces of the capacitor module 500, cooling efficiency is improved, and the cooling medium flow channel, the capacitor module 500, and the power semiconductor modules 300 and 301 are arranged orderly, whereby the entire downsizing is achieved. The cooling medium flow channels 19 are arranged along a long side of the capacitor module 500, and the distance between the cooling medium flow channels 19 and the power semiconductor modules 300 and 301 inserted and fixed to the cooling medium flow channels 19 becomes substantially constant, so that circuit constants of the smoothing capacitor and the power semiconductor module circuit are easily balanced in respective layers of the three phases, so that a circuit configuration which allows easy reduction of a spike voltage is achieved. In this embodiment, water is the most suitable as a cooling medium. However, since substances other than water may be used, it is referred to as "cooling medium".

The flow channel forming body 12 is provided with a cooling portion 407 having a space for changing the flow of the cooling medium in the interior thereof at a position facing the inlet port piping 13 and the outlet port piping 14. The cooling portion 407 is formed integrally with the flow channel forming body 12, and in this embodiment, is used for cooling the power module 350 for auxiliary equipment. The power module 350 for auxiliary equipment is fixed to a cooling surface as an outer peripheral surface of the cooling portion 407, and store the cooling medium in the space formed inside the cooling surface, and the cooling portion 407 is cooled by the cooling medium, so that the temperature rise of the power module 350 for auxiliary equipment is inhibited. The cooling medium is a cooling medium flowing in the cooling medium flow channels 19, and the power module 350 for auxiliary equipment is cooled together with the power semiconductor modules 300 and 301 and the capacitor module 500. Arranged on both sides of the semiconductor module 350 for auxiliary equipment are bus-bar assemblies 800 described later. The bus-bar assembly 800 is provided with an AC bus-bar 186 or a holding member, and holds and fixes the current sensors 180. Detailed description will be given below.

In this manner, the storage space 405 of the capacitor module 500 is provided at a center of the flow channel forming body 12, the cooling medium flow channels 19 are provided so as to interpose the storage space 405 therebetween, the power semiconductor modules 300a to 300c and the power semiconductor modules 301a to 301c for driving the vehicle are arranged in the respective cooling medium flow channels 19 and, in addition, the power module 350 for auxiliary equipment is arranged on the upper surface of the flow channel forming body 12, whereby effective cooling is achieved in a small space, and downsizing of the entire power conversion apparatus is enabled.

Also, by forming a main structure of the cooling medium flow channels 19 of the flow channel forming body 12 integrally with the flow channel forming body 12 by aluminum casting, the cooling medium flow channels 19 have an effect to enhance the mechanical strength in addition to the cooling effect. Also, by forming by the aluminum casting, the flow channel forming body 12 and the cooling medium flow channels 19 have an integral structure, and hence thermal conduction is improved and the cooling efficiency is improved. For reference, the cooling medium flow channels 19 is completed by fixing the power semiconductor modules 300a to 300c and the power semiconductor modules 301a to 301c to the cooling medium flow channels 19, a water leakage test for a water channel is performed. When the cooling medium flow channels 19 pass the the water leakage test, an operation to mount the capacitor module 500 and the power module 350 for auxiliary equipment and the substrate may be performed as a next step. The flow channel forming body 12 is arranged on the bottom portion of the power conversion apparatus 200 in this manner, and then the operation to fix required components such as the capacitor module 500, the power module 350 for auxiliary equipment, and the bus-bar assembly 800, the substrate and the like may be performed in sequence from the top, whereby the productivity and reliability are improved.

A driver circuit board 22 is arranged above the power module 350 for auxiliary equipment and the bus-bar assembly 800, that is, on the lid side. Arranged between the driver circuit board 22 and the control circuit board 20 is a metallic base plate 11, and the metallic base plate 11 has a function of an electromagnetic shield for a circuit group mounted on the driver circuit board 22 and the control circuit board 20 and has a function to radiate heat generated by the driver circuit board 22 and the control circuit board 20 and cool the same. In addition, they have a function to enhance a mechanical resonance frequency of the control circuit board 20. In other words, arrangement of screwing portions for fixing the control circuit board 20 to the metallic base plate 11 at short intervals is achieved, so that the distance between supporting points when mechanical vibrations are generated may be shortened, and the resonance frequency may be enhanced. Since the resonance frequency of the control circuit board 20 may be enhanced with respect to a vibration frequency transferred from the transmission, the control circuit board 20 is insusceptible to the vibrations and hence the reliability is improved.

Fig. 5 is an explanatory drawing for explaining the flow channel forming body 12, and is a drawing viewing the flow channel forming body 12 illustrated in Fig. 4 from below. The flow channel forming body 12 and the cooling medium flow channels 19 formed along the storage space 405 (see Fig. 4) of the capacitor module 500 in the interior of the flow channel forming body 12 are integrally casted. Formed on a lower surface of the flow channel forming body 12 is a continuously connected opening 404 and the opening 404 is closed by a lower cover 420 having an opening at the center thereof. Provided between the lower cover 420 and the flow channel forming body 12 are a sealing member 409a and a sealing member 409b to maintain air tightness.

Formed on the lower cover 420 are an inlet hole 401 for inserting an inlet port piping 13 (see Fig. 4) and an outlet hole 403 for allowing insertion of the outlet port piping 14 (see Fig. 4) near one of end sides, and along the end side. The lower cover 420 is formed with a projection 406 projecting toward the direction of arrangement of the transmission TM. The projection 406 is provided so as to correspond to the power semiconductor modules 300a to 300c and the power semiconductor modules 301a to 301c. The cooling medium flows in the direction of a flowing direction 417 illustrated by a dot line through the inlet hole 401 toward a first flow channel portion 19a formed along a short side of the flow channel forming body 12. The first flow channel portion 19a forms a space for changing the flow of the cooling medium and collides with an inner surface of the cooling portion 407 in the space, and changes the flowing direction. At the time of collision, an operation to draw heat from the cooling portion 407 is achieved. Then, the cooling medium flows in a second flow channel portion 19b formed along a longitudinal side of the flow channel forming body 12 as the flowing direction 418. Also, the cooling medium flows in a third flow channel portion 19c formed along a short side of the flow channel forming body 12 as a flowing direction 421. The third flow channel portion 19c forms a loop back flow channel. Also, the cooling medium flows in a fourth flow channel portion 19d formed along the longitudinal side of the flow channel forming body 12 as the flowing direction 422. The fourth flow channel portion 19d is provided at a position facing the second flow channel portion 19b by the intermediary of the capacitor module 500 therebetween. Furthermore, the cooling medium passes through a fifth flow channel portion 19e formed along the short side of the flow channel forming body 12 and flows out to the outlet port piping 14 through the outlet hole 403 as a flowing direction 423.

The first flow channel portion 19a, the second flow channel portion 19b, the third flow channel portion 19c and the fourth flow channel portion 19d and the fifth flow channel portion 19e are respectively formed to be larger in the depth direction than the width direction. The power semiconductor modules 300a to 300c are inserted into the openings 400a to 400c formed on the upper side of the flow channel forming body 12 (see Fig. 4), and are stored in the storage space in the second flow channel portion 19b. Formed between the storage space of the power semiconductor module 300a and the storage space of the power semiconductor module 300b is an intermediate member 408a for preventing the flow of the cooling medium from stagnating. In the same manner, formed between the storage space of the power semiconductor module 300b and the storage space of the power semiconductor module 300c is an intermediate member 408b for preventing the flow of the cooling medium from stagnating. The intermediate member 408a and the intermediate member 408b are formed so that main surfaces thereof extend along the flowing direction of the cooling medium. The fourth flow channel portion 19d also is formed with the storage space of the power semiconductor modules 301a to 301c and the intermediate member in the same manner as the second flow channel portion 19b. The flow channel forming body 12 is formed so that the opening 404 and the openings 400a to 400c and 402a to 402c face each other, and hence has a configuration which is easy to manufacture by the aluminum casting.

The lower cover 420 is provided with a supporting portion 410a and a supporting portion 410b which come into abutment with the housing 10 for supporting the power conversion apparatus 200. The supporting portion 410a is provided near one of the end sides of the lower cover 420, and the supporting portion 410b is provided near the other end side of the lower cover 420. Accordingly, the flow channel forming body 12 of the power conversion apparatus 200 may be firmly fixed to an inner wall of the housing 10 formed so as to be in conformity with a column shape of the transmission TM or the motor generator MG1.

The supporting portion 410b is configured to support a resistor 450. The resistor 450 is configured to discharge electric charge charged in a capacitor cell considering passenger protection and safety at the time of maintenance. The resistor 450 is configured so as to be capable of discharging high-voltage electricity continuously. However, a configuration giving consideration to damage on the vehicle is minimized even though the resistor or a discharging mechanism has any abnormality is necessary. In other words, when the resistor 450 is arranged in the periphery of the power semiconductor module, the capacitor module, or the driver circuit substrate or the like, if a problem such as heat generation or ignition occurs on the resistor 450, there is a probability of fire spreading in the vicinity of principal components.

Accordingly, in this embodiment, the power semiconductor modules 300a to 300c, the power semiconductor modules 301a to 301c, and the capacitor module 500 are arranged on the side opposite the housing 10 where the transmission TM is stored by the intermediary of the flow channel forming body 12, and the resistor 450 is arranged in a space between the flow channel forming body 12 and the housing 10. Accordingly, the resistor 450 is arranged in a closed space surrounded by the flow channel forming body 12 formed of a metal and the housing 10. The charge accumulated in the capacitor cell in the capacitor module 500 is controlled in discharge by the resistor 450 via a wiring passing along a side portion of the flow channel forming body 12 by the switching operation of a switching unit mounted on the driver circuit board 22 illustrated in Fig. 4. In this embodiment, the switching unit controls to achieve high-speed discharging. Since the flow channel forming body 12 is provided between the driver circuit board 22 and the resistor 450 which control the discharge, the driver circuit board 22 may be protected from the resistor 450. Since the resistor 450 is fixed to the lower cover 420, and hence is provided at a position thermally very close to the cooling medium flow channels 19, so that the abnormal heat generation of the resistor 450 is inhibited.

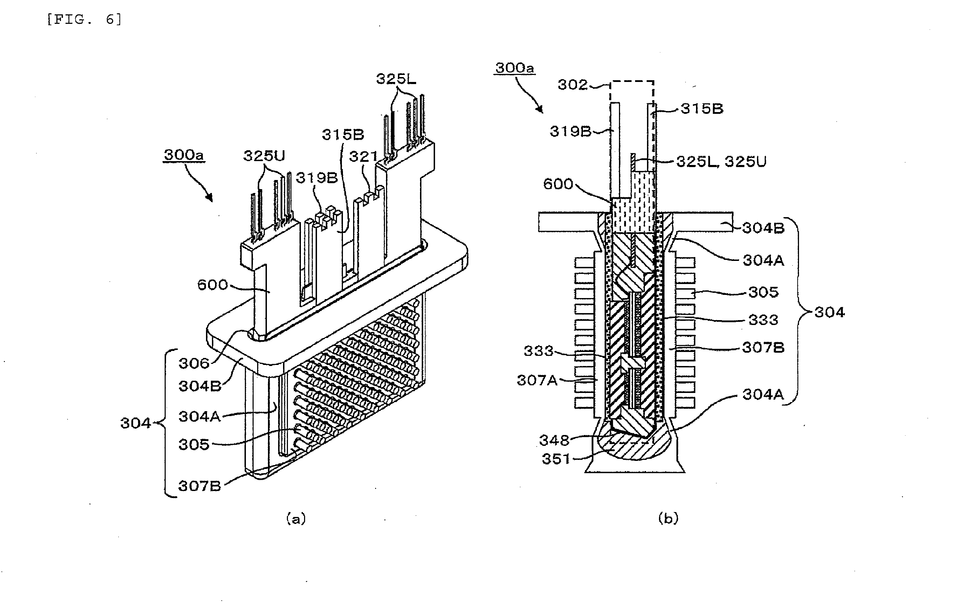

Referring now to Fig. 6 to Fig. 10, detailed configurations of the power semiconductor modules 300a to 300c and the power semiconductor modules 301a to 301c used in the inverter circuit 140 and the inverter circuit 142 will be described. All of the power semiconductor modules 300a to 300c and the power semiconductor modules 301a to 301c have the same structure, and hence the structure of the power semiconductor module 300a will be described as a representative. In Fig. 6 to Fig. 10, signal terminals 325U correspond to the gate electrode 154 and the emitter electrode 155 disclosed in Fig. 2, and signal terminals 325L corresponds to the gate electrode 164 and the emitter electrode 165 disclosed in Fig. 2. Also, a DC positive terminal 315B is the same as the positive terminal 157 disclosed in Fig. 2, and a DC negative terminal 319B is the same as the negative terminal 158 disclosed in Fig. 2. An AC terminal 321 is the same as the AC terminal 159 disclosed in Fig. 2.

Fig. 6(a) is a perspective view of the power semiconductor module 300a of this embodiment. Fig. 6(b) is a cross-sectional view of the power semiconductor module 300a of this embodiment.

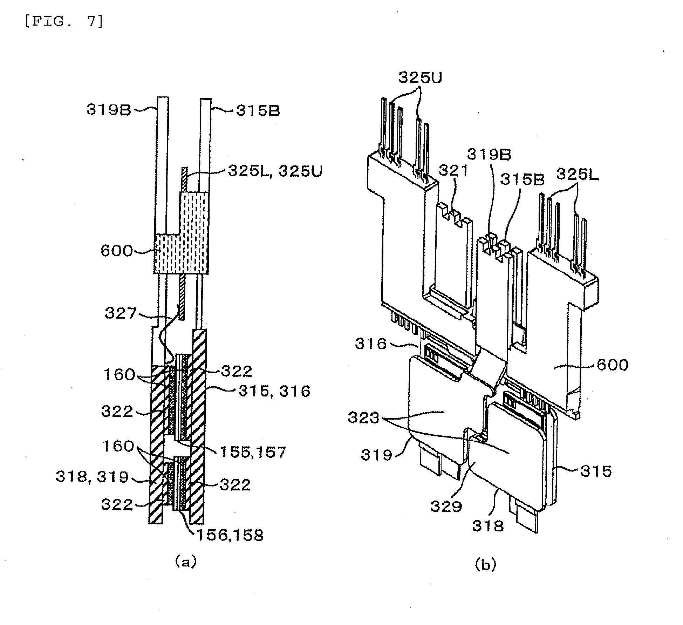

The power semiconductor elements (IGBT 328, IGBT 330, diodes 156, diodes 166) which constitute the upper and lower arm series circuit 150 are secured by being held tightly between a conductive plate 315 and a conductive plate 318 or between a conductive plate 316 and a conductive plate 319 from both sides as illustrated in Fig. 7 to Fig. 9. An auxiliary mold body 600 formed by integrally molding signal wiring such as the signal terminals 325U and the signal terminals 325L is assembled to these conductive plates. The conductive plate 315 and the like are sealed by a first sealing resin 348 in a state in which a thermal radiating surface is exposed, and an insulative sheet 333 is thermally pressure-bonded to the thermal radiating surface. A module primary sealing body 302 sealed by the first sealing resin 348 is inserted into a module case 304, and is thermally pressure-bonded to an inner surface of the module case 304 as a CAN type cooler by the intermediary of the insulative sheet 333. Here, the CAN type cooler is a cooler of a cylindrical shape having an insertion port 306 on one surface and a bottom on the other surface.

The module case 304 is formed of aluminum alloy such as Al, AlSi, AlSic, Al-C, and the like and is integrally molded in a state having no seam. The module case 304 has a structure having no opening other than the insertion port 306, and an outer periphery of the insertion port 306 is surrounded by the flange 304B. As illustrated in Fig. 6(a), a first thermal radiating surface 307A and a second thermal radiating surface 307B having a surface area larger than other surfaces are arranged in a state of facing each other, and three surfaces connecting the first thermal radiating surface 307A and the second thermal radiating surface 307B facing each other have a width narrower than the first thermal radiating surface 307A and the second thermal radiating surface 307B and constitute sealed surfaces, and the insertion port 306 is formed on a surface of remaining one side. The shape of the module case 304 does not have to be an accurate cuboid, and corners may be formed into curved surfaces as illustrated in Fig. 6(a).

By using a metallic case in this shape, even when the module case 304 is inserted into the cooling medium flow channels 19 in which a cooling medium such as water or oil flows, a seal with respect to the cooling medium may be secured by the flange 304B, so that entry of the cooling medium into the interior of the module case 304 may be prevented with a simple configuration. The first thermal radiating surface 307A and the second thermal radiating surface 307B facing each other are formed respectively with fins 305 uniformly. In addition, outer peripheries of the first thermal radiating surface 307A and the second thermal radiating surface 307B are formed with an extremely thinned curved portion 304A. Since the curved portion 304A is extremely thinned to an extent of easily deformed by pressing the fins 305, so that the productivity after the insertion of the module primary sealing body 302 is improved.

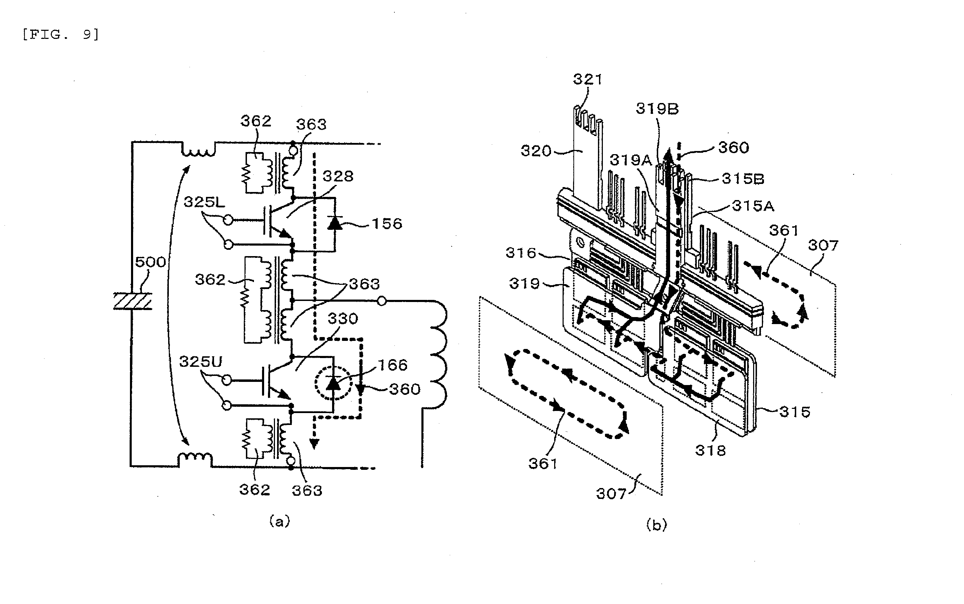

A gap remaining in the interior of the module case 304 is filled with a secondary sealing resin 351. As illustrated in Fig. 8 and Fig. 9, a DC positive wiring 315A and a DC negative wiring 319A for an electrical connection with the capacitor module 500 are provided, and the DC positive terminal 315B (157) and the DC negative terminal 319B (158) are formed at distal end portions thereof. An AC wiring 320 for supplying AC power to the motor generator MG1 or 194 is provided and an AC terminal 321 (159) is provided at a distal end thereof. In this embodiment, the DC positive wiring 315A is integrally formed with the conductive plate 315, and the DC negative wiring 319A is formed integrally with the conductive plate 319, and the AC wiring 320 is integrally formed with the conductive plate 316.

As described above, the gap between the conductive plate and inner walls of the module case 304 may be reduced by thermally pressure bonding the conductive plate 315 or the like to the inner wall of the module case 304 via the insulating sheet 333, so that heat generated by the power semiconductor elements may be transmitted to the fins 305 efficiently. Furthermore, generation of thermal stress may be absorbed by the insulating sheet 333 by providing the insulating sheet 333 with the thickness and flexibility to some extent, so that it is suitable to be used in the power conversion apparatus for a vehicle being subject to wide temperature variations.

Fig. 7 (a) is an interior cross-sectional view in a state in which the module case 304, the insulating sheet 333, the first sealing resin 348, and the secondary sealing resin 351 are removed for the sake of easy understanding. Fig. 7(b) is an interior perspective view. Fig. 8 (a) is an exploded perspective view for the sake of easy understanding of the structure in Fig. 7 (b). Fig. 8 (b) is a circuit diagram of the power semiconductor module 300. Fig. 9 (a) is a circuit diagram for explaining an effect of reduction of an inductance, and Fig. 9(b) is a perspective view for illustrating the flow of the current for explaining the action of reduction of the inductance.

First of all, the arrangement of the power semiconductor elements (IGBT328, IGBT 330, diodes 156, diodes 166) and the conductive plates will be described in conjunction with the electric circuit illustrated in Fig. 8(b). As illustrated in Fig. 7(b), the conductive plate 315 on the DC positive side and the conductive plate 316 on the AC output side are arranged on the substantially same plane. A collector electrode of the IGBT 328 on the upper arm side and a cathode electrode of the diodes 156 on the upper arm side are secured on the conductive plate 315. A collector electrode of the IGBT 330 on the lower arm side and a cathode electrode of the diodes 166 on the lower arm side are secured on the conductive plate 316. In the same manner, the AC conductive plate 318 and the conductive plate 319 are arranged in the substantially same plane. An emitter electrode of the IGBT 328 on the upper arm side and an anode electrode of the diodes 156 on the upper arm side are secured to the AC conductive plate 318. An emitter electrode of the IGBT 330 on the lower arm side and an anode electrode of the diodes 166 on the lower arm side are secured to the conductive plate 319. Each of the power semiconductor elements is secured to an element securing portion 322 provided on each of the conductive plates via a metal joint member 160. Examples of the metal joint member 160 include, for example, a soldering material, a silver sheet, and a low-temperature sintering joint material containing fine metallic particles.

The respective power semiconductor elements have a plate-like flat structure, and the respective electrodes of the power semiconductor elements are formed on front and back sides. As illustrated in Fig. 7 (a), the respective electrodes of the power semiconductor elements are held between the conductive plate 315 and the conductive plate 318, or between the conductive plate 316 and the conductive plate 319. In other words, the conductive plate 315 and the conductive plate 318 have a laminated arrangement facing in substantially parallel to each other via the IGBT 328 and the diodes 156. In the same manner, the conductive plate 316 and the conductive plate 319 have a laminated arrangement facing in substantially parallel to each other via the IGBT 330 and the diodes 166. Also, the conductive plate 316 and the conductive plate 318 are connected via an intermediate electrode 329. With this connection, an upper arm circuit and a lower arm circuit are electrically connected, thereby forming the upper and lower arm series circuit.

The DC positive wiring 315A and the DC negative wiring 319A extend substantially in parallel so as to face each other via the auxiliary mold body 600 formed of a resin material. The signal terminals 325U and the signal terminals 325L are formed integrally with the auxiliary mold body 600, and extends in the same direction as the DC positive wiring 315A and the DC negative wiring 319A. The resin material suitable to be used for the auxiliary mold body 600 is a thermosetting resin or thermoplastic resin having insulating properties. Accordingly, the insulating properties among the DC positive wiring 315A, the DC negative wiring 319A, the signal terminals 325U, and the signal terminals 325L may be secured, and a high-density wiring is enabled. In addition, by the arrangement of the DC positive wiring 315A and the DC negative wiring 319A so as to be substantially parallel to each other, electric currents flowing instantaneously at the time of switching operation of the power semiconductor elements flow so as to face in the opposite direction. Accordingly, magnetic fields generated by electric currents act to cancel each other out, whereby the reduction of inductance is achieved.

An action to elicit the reduction of inductance will be described with reference to Fig. 9(a). In Fig. 9(a), the diodes 166 on the lower arm side are brought into a state of being in conduction in a forward biased state. When the IGBT 328 on the upper arm side is brought into an ON state in this state, the diodes 166 on the lower arm side is biased in the opposite direction, and a recovery current caused by a carrier movement passes through the upper and lower arms. At this time, a recovery current 360 illustrated in Fig. 9(b) flows through the respective conductive plates 315, 316, 318, and 319. The recovery current 360 passes through the DC positive terminal 315B (157) arranged so as to face the DC negative terminal 319B (158) as illustrated by a dot line, then flows through a loop-shaped route formed by the respective conductive plates 315, 316, 318, and 319, and flows as illustrated by a solid line via the DC negative terminal 319B (158) arranged so as to face the DC positive terminal 315B (157) again. By the flow of the electric current through the loop-shaped route, an eddy current 361 flows on the first thermal radiating surface 307A and the second thermal radiating surface 307B of the module case 304. Owing to a magnetic field cancellation effect in a current route of the eddy current 361 generated by an equivalent circuit 362, reduction of a wiring inductance 363 in the loop-shaped route is achieved.

The closer the current route of the recovery current 360 to the loop shape, the larger effect of the reduction of the inductance is obtained. In this embodiment, as illustrated by a dot line, current flows through a loop-shaped current route near the DC positive terminal 315B (157) side of the conductive plate 315 and passes within the IGBT 328 and the diodes 156. Then, as illustrated by a solid line, current flows through a loop-shaped current route farther from the DC positive terminal 315B (157) side of the conductive plate 318, then as illustrated by the dot line, flows through the route farther from the DC positive terminal 315B (157) side of the conductive plate 316, and passes within the IGBT 330 an the diodes 166. Furthermore, as illustrated by a solid line, current flows through a loop-shaped current route close to the DC negative wiring 319A side of the conductive plate 319. In this manner, by the current passing through the loop-shaped current route on the near side or the far side with respect to the DC positive terminal 315B (157) or the DC negative terminal 319B (158), the current route closer to the loop shape is formed.

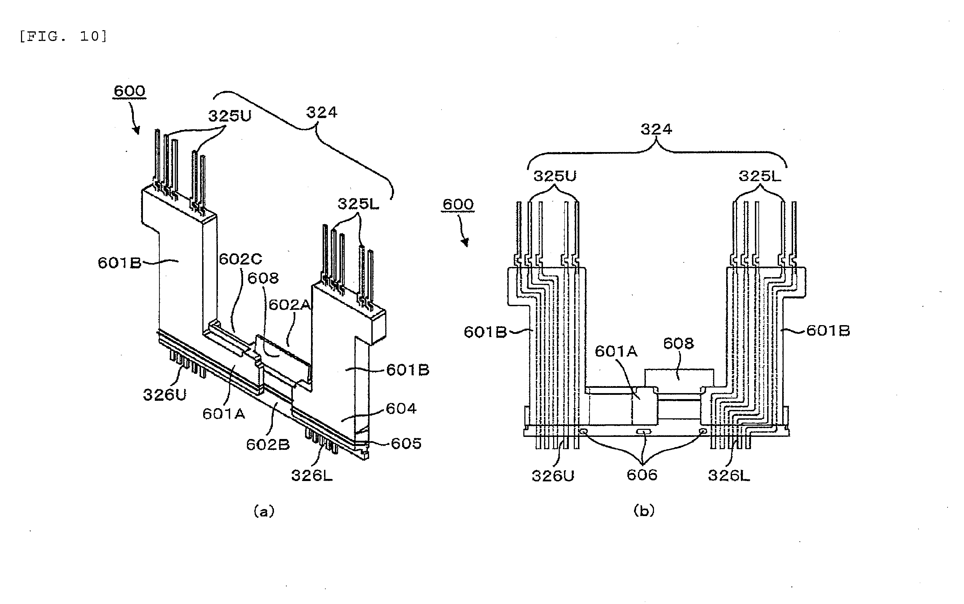

Fig. 10 (a) is a perspective view of the auxiliary mold body 600, and Fig 10 (b) is a transmissive image drawing of the auxiliary mold body 600.

The auxiliary mold body 600 integrates a signal conductor 324 by insert molding. Here, the signal conductor 324 includes the gate electrode terminal 154 and the emitter electrode terminal 155 on the upper arm side, the gate electrode terminal 164 and the emitter electrode terminal 165 on the upper arm side (see Fig. 2), and the terminal for transmitting the temperature information of the power semiconductor elements. In the description of the embodiment, these terminals are collectively expressed as the signal terminals 325U and 325L.

The signal conductor 324 is formed with the signal terminals 325U and 325L on one end portion and element side signal terminals 326U and 326L on the other end portion. The element side signal terminals 326U and 326L are connected to signal pads provided on surface electrodes of the power semiconductor elements by, for example, wires. A first sealing portion 601A has a form extending in the direction across a longitudinal axis of the shape of the DC positive wiring 315A, the DC negative wiring 319A or the AC wiring 320 illustrated in Fig. 8(a). In contrast, a second sealing portion 601B has a form extending in the direction substantially parallel to the longitudinal axis of the shape of the DC positive wiring 315A, the DC negative wiring 319A, or the AC wiring 320. Also, the second sealing portion 601B includes a sealing portion configured to seal the signal terminals 325U on the upper arm side and a sealing portion configured to seal the signal terminals 325L on the lower arm side.

The auxiliary mold body 600 is formed to have a length longer than the entire length of the conductive plates 315 and 316 arranged side by side or the entire length of the conductive plates 319 and 320 arranged side by side. In other words, the length of the conductive plates 315 and 316 arranged side by side or the length of the conductive plates 319 and 320 arranged side by side are within a range of the lateral length of the auxiliary mold body 600.

The First sealing portion 601A has a depressed shape and forms a wiring fitting portion 602B for allowing fitting of the DC negative wiring 319A into the depression. Also, the first sealing portion 601A has a depressed shape and forms a wiring fitting portion 602A for allowing fitting of the DC positive wiring 315A into the depression. In addition, the first sealing portion 601A is arranged on the side of the wiring fitting portion 602A, has a depressed shape, and further forms a wiring fitting portion 602C for allowing fitting of the AC wiring 320 into the depression. With the wiring fitted into the respective wiring fitting portions 602A to 602C, positioning of the respective wiring is achieved. Accordingly, filling operation of a resin sealing material may be performed after having firmly fixed the respective wiring, so that the mass-productivity is improved.

A wiring insulating portion 608 projects from between the wiring fitting portion 602A and the wiring fitting portion 602B in the direction away from the first sealing portion 601A. By the intermediary of the wiring insulating portion 608 formed into a plate shape between the DC positive wiring 315A and the DC negative wiring 319A, a facing arrangement for the reduction of the inductance is achieved while ensuring the insulating property.

The first sealing portion 601A is formed with a die pressing surface 604 coming into contact with a die used at the time of resin sealing, and the die pressing surface 604 is formed with projecting portions 605 for preventing leakage of the resin at the time of the resin sealing along a full circle of an outer periphery of a first sealing portion 601A in the longitudinal direction. A plurality of the projecting portions 605 are provided for enhancing the resin leakage preventing effect. Furthermore, since the projecting portions 605 are provided also on the wiring fitting portion 602A and the wiring fitting portion 602B, the leakage of the resin sealing material from the peripheries of the DC positive wiring 315A and the DC negative wiring 319A. Here, examples of the preferable material of the first sealing portion 601A, the second sealing portion 601B, and the projecting portions 605 include thermoplastic resin such as liquid crystal polymer, polybutylene-terephthalate (PBT) and polyphenylene sulphide resin (PPS) from which a heat resistance property is expected when considering that the material is installed in the die at temperatures on the order of 150 to 180°C.

A plurality of through holes 606 illustrated in Fig. 10 (b) are provided in the longitudinal direction on the side of the power semiconductor element of the first sealing portion 601A in the short side direction. Accordingly, by the first sealing resin 348 flowing into the through holes 606 and hardened, anchoring effect is presented and hence the auxiliary mold body 600 is firmly held by the first sealing resin 348, so that the both do not separate from each other even when a stress is applied by being subjected to the temperature variations or mechanical vibrations. Projections and convection may be used instead of the through holes for resisting separation. Also, applying a polyimide-based coating agent on the first sealing portion 601A, or roughening the surface may promise a certain level of effect.

In the sealing process of the first sealing resin 348 of the module primary sealing body 302, the auxiliary mold body 600 supporting the respective wiring is inserted into a die preheated to a temperature on the order of 150 to 180°C. In this embodiment, since the auxiliary mold body 600, the DC positive wiring 315A, the DC negative wiring 319A, the AC wiring 320, the conductive plate 315, the conductive plate 316, the conductive plate 318, and the conductive plate 319 are firmly connected, the principal circuit and the power semiconductor elements are installed at predetermined positions by installing the auxiliary mold body 600 at a predetermined position. Therefore, the productivity is improved and the reliability is improved.

Also, the second sealing portion 601B is formed so as to extend from the vicinity of the module case 304 to the vicinity of the driver circuit board 22. Accordingly, when achieving wiring with the driver circuit board 22 while running among heavy voltage wirings, a switching control signal may be transferred correctly even when being exposed to the high voltage. The electrical insulation may be ensured by causing the DC positive wiring 315A, the DC negative wiring 319A, the AC wiring 320, the signal terminals 325U and the signal terminals 325L to project from the module case 304 in the same direction, so that the reliability is ensured.

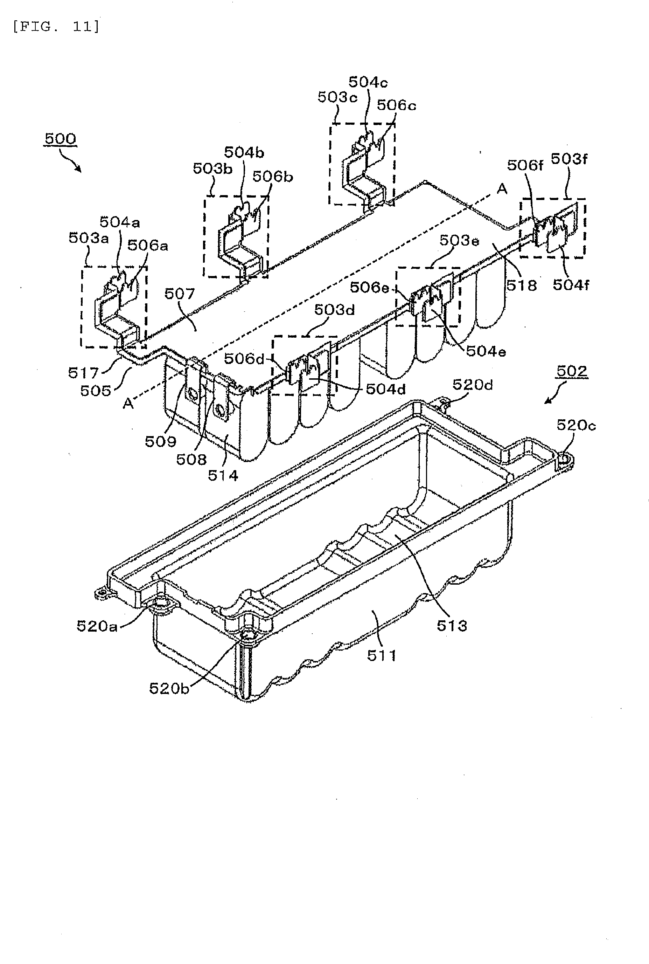

Fig. 11 is an exploded perspective view for explaining an internal structure of the capacitor module 500. An laminated conductive plate 501 includes a negative conductive plate 505 and a positive conductive plate 507 formed of plate-shaped wide conductors, and an insulative sheet 517 held between the negative conductive plate 505 and the positive conductive plate 507. Since the laminated conductive plate 501 cancels out magnetic fluxes with respect to electric currents flowing through the upper and lower arm series circuits 150 of the respective phases as described below, reduction of the inductance of the current flowing through the upper and lower arm series circuits150 is achieved. The laminated conductive plate 501 is formed into a substantially rectangular shape. The negative-side power supply terminal 508 and the positive-side power supply terminal 509 are formed in a state of rising from one of the short sides of the laminated conductive plate 501, and are connected to the positive conductive plate 507 and the negative conductive plate 505, respectively. As described in conjunction with Fig. 2, DC power is supplied to the positive-side power supply terminal 509 and the negative-side power supply terminal 508 via the DC connector 138.

Capacitor terminals 503a to 503c are formed corresponding to the positive terminal 157 (315B) and the negative terminal 158 (319B) of the power semiconductor modules 300, respectively in a state of rising from one of the longitudinal sides of the laminated conductive plate 501. Also, capacitor terminals 503d to 503f are formed corresponding to the positive terminal 157 (315B) and the negative terminal 158 (319B) of the power semiconductor modules 301, respectively in a state of rising from the other side of the laminated conductive plate 501 in the longitudinal direction. The capacitor terminal 503a to 503f rise in the direction across a main surface of the laminated conductive plate 501. The capacitor terminals 503a to 503c are connected respectively to the power semiconductor modules 300a to 300c. The capacitor terminals 503d to 503f are connected respectively to the power semiconductor modules 301a to 301c. Provided between a negative-side capacitor terminal 504a and a positive-side capacitor terminal 506a which constitute the capacitor terminal 503a is part of the insulative sheet 517, and insulation is ensured. The capacitor terminals 503b to 503f are also the same. In this embodiment, the negative conductive plate 505, the positive conductive plate 507, the positive-side power supply terminal 508, the negative-side power supply terminal 509 and the capacitor terminal 503a to 503f are formed of an integrally molded metallic plate, and has the effect of reduction of the inductance with respect to the electric current flowing through the upper and lower arm series circuits 150.

A plurality of capacitor cells 514 are provided inside the capacitor module 500 which is located downward of the laminated conductive plate 501.. In the embodiment, eight of the capacitor cells 514 are arranged in a row along one of the longitudinal sides of the laminated conductive plate 501, and another eight of the capacitor cells 514 are arranged in a row along the other longitudinal side of the laminated conductive plate 501, so that sixteen in total of the capacitor cells are provided. The capacitor cells 514 arranged along the respective longitudinal sides of the laminated conductive plate 501 are arranged symmetrically with respect to a dot line AA illustrated in Fig. 11 as a boundary. Accordingly, when the DC current smoothed by the capacitor cells 514 is supplied to the power semiconductor modules 300a to 300c and the power semiconductor modules 301a to 301c, the current balance between the capacitor terminals 503a to 503c and the capacitor terminals 503d to 503f are uniformized, so that the reduction of the inductance of the laminated conductive plate 501 is achieved. Since the local flow of the current in the laminated conductive plate 501 is prevented, the thermal balance is uniformized and improvement of heat resistance may be achieved.

Since a number of the capacitor cells 514 are arranged in the direction along the cooling medium flow channel, uniformization tends to be achieved easily with respect to the upper and lower arm series circuits 150 of the U-phase, the V-phase, and the W-phase of the power semiconductor modules 300 and the power semiconductor module 301 arranged along the cooling medium flow channel. Also, an effect of cooling the respective capacitor cells 514 by the cooling medium further uniformly is achieved. Furthermore, the current balance between the capacitor terminals 503a to 503c and the capacitor terminals 503d to 503f is uniformized and hence the reduction of the inductance of the laminated conductive plate 501 is achieved and, simultaneously, the thermal balance is uniformized, so that improvement of the heat resistance is also achieved.

The capacitor cell 514 is a unit structure of a capacitance portion of the capacitor module 500 using a film capacitor formed by laminating and rolling two films each deposited with a metal such as aluminum on one side thereof, and polarizing the two metals respectively to a positive pole and a negative pole. A winding axis plane of the capacitor cells 514 serves as the positive polar and the negative polar, which is manufactured by blowing conductive material such as tin.

A capacitor case 502 includes a storage portion 511 for storing the capacitor cells 514, and the storage portion 511 illustrated in the drawing has an upper surface and a lower surface formed into a substantially rectangular shape. The capacitor case 502 is formed with holes 520a to 520h for allowing fixing devices for securing the capacitor module 500 to the flow channel forming body 12, such as screws, to penetrate therethrough. With the provision of the hole 520b, the hole 520c, the hole 520f, and the hole 520g with respect to the power semiconductor modules, air-tightness between the power semiconductor modules and the cooling medium flow channels 19 is improved. A bottom surface portion 513 of the storage portion 511 has a smooth concavo-convex shape or a wave shape so as to be in conformity to the surface shape of the cylindrical capacitor cells 514. Accordingly, positioning of the module in which the laminated conductive plate 501 and the capacitor cells 514 are connected in the capacitor case 502 is easily achieved. Also, after having stored the laminated conductive plate 501 and the capacitor cells 514 in the capacitor case 502, the capacitor terminals 503a to 503f, the negative-side power supply terminal 508 and the positive-side power supply terminal 509 are removed, and then the interior of the capacitor case 502 is filled with filler (not illustrated) so as to cover the laminated conductive plate 501. Since the bottom surface portion 513 has a wave shape in conformity to the shape of the capacitor cells 514, displacement of the capacitor cells 514 from a predetermined position when the interior of the capacitor case 502 is filled with the filler is prevented.

The capacitor cells 514 generate heat by electric resistance of a metallic thin film deposited on the interior film and the interior conducting material generated by a ripple current at the time of switching. Accordingly, in order to allow the heat of the capacitor cells 514 to be released easily via the capacitor case 502, the capacitor cells 514 are molded with the filler. By the usage of resin-made filler, humidity resistance of the capacitor cells 514 is also improved. In this embodiment, the cooling medium flow channels are provided along the longitudinal direction of the storage portion 511 of the capacitor module 500, and hence the cooling efficiency is improved. In addition, in this embodiment, the capacitor module 500 is arranged so that side walls which form longitudinal sides of the storage portion 511 are held between the cooling medium flow channels 19, the capacitor module 500 may be cooled efficiently. Also, the capacitor cells 514 are arranged so that one of electrode surfaces of each of the capacitor cells 514 faces an inner wall which constitutes a longitudinal side of the storage portion 511. Accordingly, since the heat is transferred easily in the direction of the winding axis of the films, the heat can be released easily to the capacitor case 502 via the electrode surfaces of the capacitor cells 514.

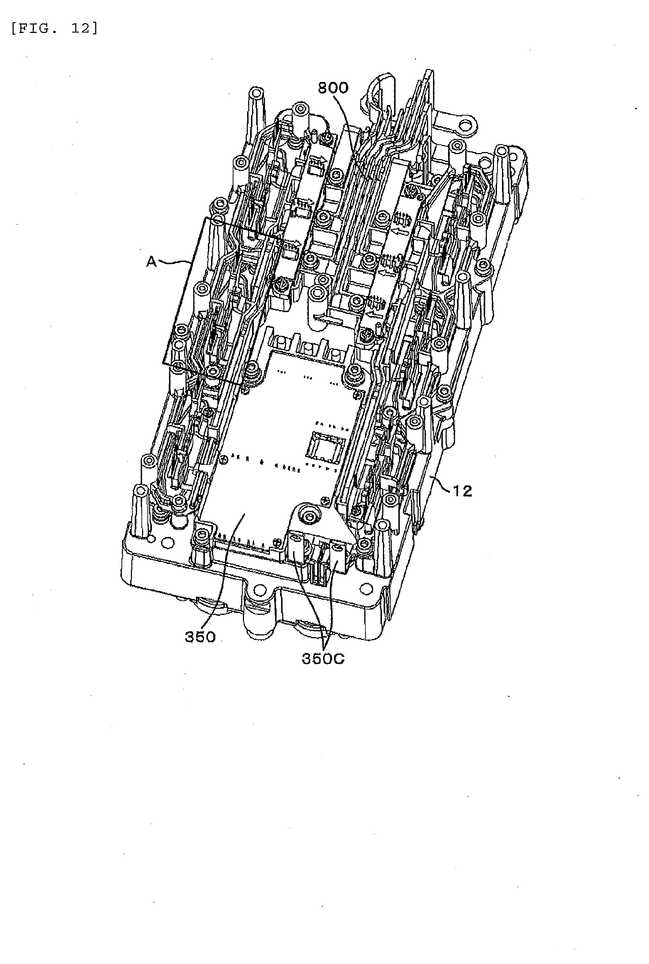

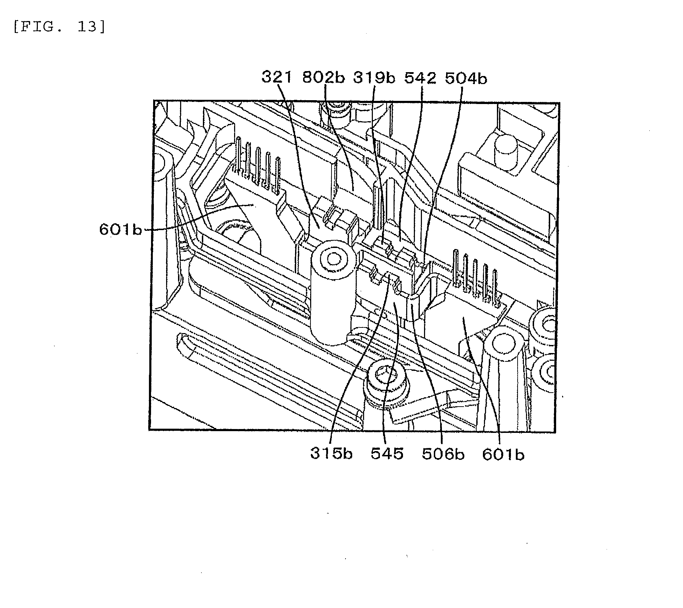

In the following description, the DC positive terminal 315B and the positive terminal 157 illustrated in Fig. 2 are the same thing. Also, the DC negative terminal 319B and the negative terminal 158 illustrated in Fig. 2 are the same thing. Fig. 12 is an appearance perspective view illustrating a state in which the power semiconductor module, a capacitor module, and a bus-bar assembly assembled to the flow channel forming body 12. Fig. 13 is an enlarged drawing of a portion A in Fig. 12. In Fig. 11 and Fig. 12 and Fig. 13, the DC positive terminal 315B (157), the DC negative terminal 319B (158), the AC terminal 321 (159), and the second sealing portion 601B extend in the vertical direction toward the lid side of the housing 10. The surface areas of the current routes of the DC positive terminal 315B (157) and the DC negative terminal 319B (158) are significantly smaller than the surface area of the current route of the laminated conductive plate 501. Therefore, when the electric current flows from the laminated conductive plate 501 to the DC positive terminal 315B (157) and the DC negative terminal 319B (158), the surface areas of the current routes significantly change. In other words, the electric current concentrates to the DC positive terminal 315B (157) and the DC negative terminal 319B (158). Also, when the DC positive terminal 315B (157) and the DC negative terminal 319B (158) project in the direction across the laminated conductive plate 501, in other words, when the DC positive terminal 315B (157) and the DC negative terminal 319B (158) are in the twisted relationship with respect to the laminated conductive plate 501, a new connecting conductor is required and hence there arises a probability of lowering of the productivity and cost increase.

Therefore, in this embodiment, the negative-side capacitor terminal 504a has a rising portion rising from the laminated conductive plate 501, a connecting portion 542 at a distal end portion thereof. Also, the positive-side capacitor terminal 506a has a rising portion rising from the laminated conductive plate 501, a connecting portion 545 at a distal end portion thereof. The DC negative terminal 319B (158) or the DC positive terminal 315B (157) of the power semiconductor modules 300 and 301 are connected so as to be held between the connecting portion 542 and the connecting portion 545. Accordingly, since the capacitor terminals 504a and 506a form a laminated structure via the insulative sheet until immediately before the connecting portions 542 and 545, the reduction of the inductance at wiring portions of the capacitor terminal 504a or 506a where the electric current concentrates is achieved. In addition, the distal end of the DC negative terminal 319B (158) and a lateral side of the connecting portion 542 are connected by welding and, in the same manner, the distal end of the DC positive terminal 315B (157) and a lateral side of the connecting portion 545 are connected by welding. Accordingly, in addition to improvement in characteristic on the basis of the reduction of the inductance, improvement of the productivity is achieved.

The distal ends of the AC terminals 321 (159) of the power semiconductor modules 300 or 301 are connected to the distal end of an AC bus-bar 802 by welding. In the production equipment for welding, allowing a welding machine to be movable in the plurality of directions with respect to the object of welding may lead to complicated production equipment, which is not preferable in terms of the productivity and the cost. Therefore, in this embodiment, a welding point of the AC terminal 321 (159) and a welding point of the DC negative terminal 319B (158) are arranged in a straight line along the longitudinal side of the flow channel forming body 12. Accordingly, welding of a plurality of points may be performed while moving the welding machine in one direction, so that the productivity is improved.

In addition, as illustrated in Fig. 4 and Fig. 12, the plurality of power semiconductor modules 300a to 300c are arranged in a straight line along the longitudinal side of the flow channel forming body 12. Accordingly, when welding the plurality of power semiconductor modules 300a to 300c, further improvement of the productivity is achieved.

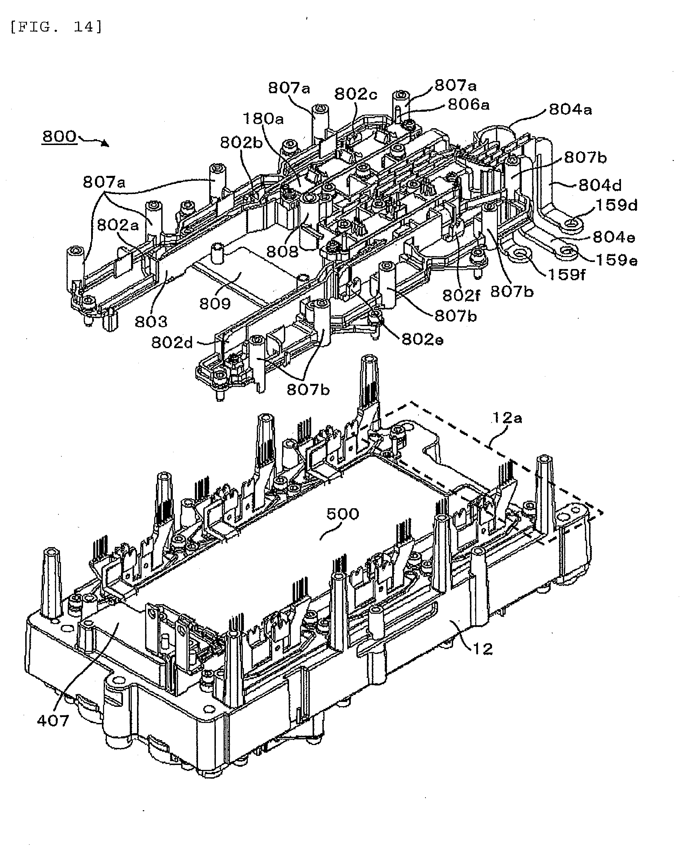

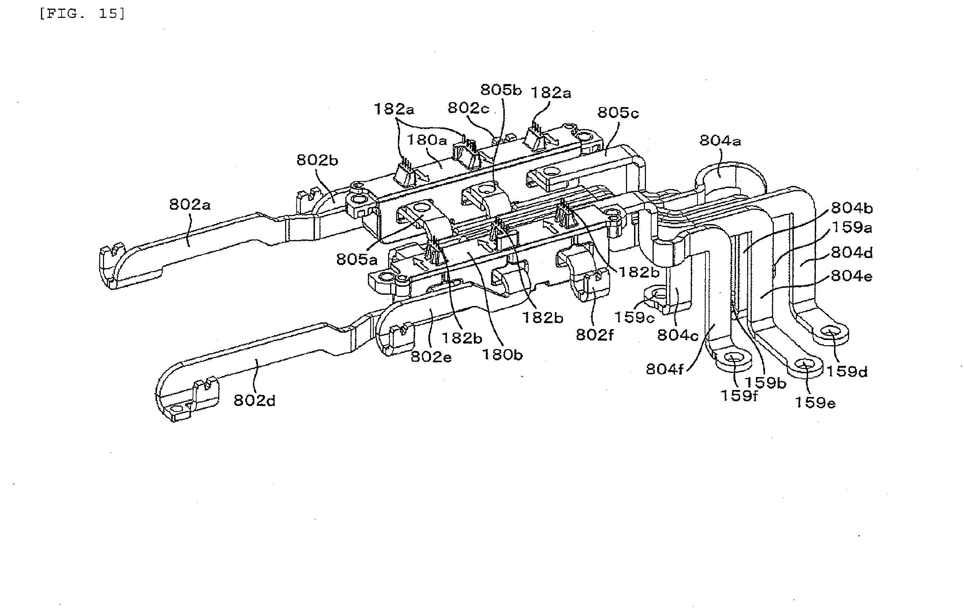

Fig. 14 is an exploded perspective view illustrating the flow channel forming body 12 to which the power semiconductor module and the capacitor module are assembled and the bus-bar assembly 800. Fig. 15 is an appearance perspective view of the bus-bar assembly 800 from which the holding member 803 is removed. In Fig. 14 and Fig. 15, the bus-bar assembly 800 includes the holding member 803 configured to hold and fix first and second AC bus-bars arranged on both sides, first AC bus-bar 802a to 802f provided on the both sides, and second AC bus-bars 804a to 804f. The bus-bar assembly 800 is further provided with the current sensors 180 configured to detect the AC current flowing through the first and second AC bus-bars 802 and 804 provided on the both sides. The AC bus-bars 802 and 804 provided on both sides are respectively formed of wide conductors, and the first AC bus-bars 802a to 802f on the both sides are arranged so that the wide surfaces extend substantially perpendicularly with respect to the main surface of the laminated conductive plate 501 of the capacitor module 500 until the point of installation of a current sensor 180a and a current sensor 180b. The first AC bus-bars 802a to 802f are bent respectively before through holes of the current sensor 180a and 180b at a substantially right angle, and the wide surfaces of the AC bus-bars extend in substantially parallel to the main surface of the laminated conductive plate 501. After having passed through the holes of the current sensor 180a and the current sensor 180b, the first AC bus-bar 802a to 802f are connected to the second AC bus-bars 804a to 804f. Most part of the second AC bus-bars 804a to 804f are in a state in which the wide surfaces extend substantially perpendicular to the main surface of the laminated conductive plate 501 of the capacitor module 500, that is, narrow surfaces of the AC bus-bars face the vertical direction of the power conversion apparatus. As illustrated in Fig. 15, the first AC bus-bars 802a to 802f, after having passed through the holes of the current sensor 180a and the current sensor 180b, are connected to the second AC bus-bars 804a to 804f at connecting portions 805a to 805f formed on the first AC bus-bars 802a to 802f (connecting portions 805d to 805f are not illustrated).

As described above, the second AC bus-bars 804a to 804f are bent in the vicinity of the connecting portions 805a to 805f at substantially a right angle toward the capacitor module 500. Accordingly, the main surfaces of the second current bus-bars 804a to 804f are formed so as to extend substantially perpendicularly to main surface of the laminated conductive plate 501 of the capacitor module 500. Furthermore, the second AC bus-bars 804a to 804f extend from the vicinity of the current sensor 180a and the current sensor 180b toward a side 12a on one side in the short side direction of the flow channel forming body 12 as illustrated in Fig. 12, Fig. 14 and Fig. 15, and is formed so as to extend across the side 12a. In other words, the plurality of second AC bus-bars 804a to 804f are formed so as to extend across the side 12a in a state in which the main surfaces thereof face each other.

By the arrangement of the AC bus-bars 802a, 802b, 802d and 802e on the both sides along the cooling medium flow channels arranged on both sides inside the housing 10, upsizing of the entire apparatus is alleviated. Also, since the narrow surface of the wide conductors are arranged so as to be aligned in the vertical direction of the apparatus, the space occupied by the first AC bus-bar 802 or the second AC bus-bar 804 may be reduced, and hence upsizing of the entire apparatus may be alleviated. Furthermore, by causing the plurality of AC bus-bars to project from one surface side of the flow channel forming body 12, routing of the wiring on the outside of the power conversion apparatus 200 is facilitated, and hence the productivity is improved.

As illustrated in Fig. 14, the first AC bus-bars 802a to 802f, the current sensors 180a to 180b, and the second current bus-bars 804a to 804f are held and insulated by the holding member 803 formed of resin. With the holding member 803, the second AC bus-bars 804a to 804f improve the insulating properties between the metallic flow channel forming body 12 and the housing 10.

The bus-bar assembly 800 has a configuration to be fixed to the flow channel forming body 12 by the holding member 803. Even if the heat is transferred to the housing 10 from the outside, the flow channel forming body 12 formed with the flow channels for the cooling medium is inhibited from the temperature rise. By fixing the bus-bar assembly 800 to the flow channel forming body 12, not only the temperature rise of the bus-bar assembly 800 is inhibited, but also the temperature rises of the current sensors 180 held by the bus-bar assembly 800 may be inhibited. The current sensors 180 have a characteristic vulnerable to heat, and hence improvement of the reliability of the current sensors 180a to 180b is achieved by the above-described structure. Furthermore, as described in this example, when the power conversion apparatus is fixed to a transmission, heat is transferred to the housing 10 not only from the transmission TM side, but also from the motor generator side via the second AC bus-bars 804a to 804f. The heat is blocked by the flow channel forming body 12, or the heat may be released to the cooling medium, the temperature rise of the current sensors 180a to 180b may be inhibited, and the improvement of the reliability is achieved.

As illustrated in fig. 14, the holding member 803 is provided with supporting members 807a and supporting members 807b for supporting the driver circuit board 22 illustrated in Fig. 4. A plurality of the supporting members 807a are provided and are formed along one of the longitudinal sides of the flow channel forming body 12. Also, a plurality of the supporting members 807b are provided and are formed in a line along the other longitudinal side of the flow channel forming body 12. Screw holes for fixing the driver circuit board 22 are formed at distal end portions of the supporting members 807a and the supporting members 807b.

Furthermore, the holding member 803 has a projecting portion 806a and a projecting portion 806b extending upward from points where the current sensor 180a and the current sensor 180b are arranged. The projecting portion 806a and the projecting portion 806b are configured so as to penetrate through the current sensor 180a and the current sensor 180b, respectively. As illustrated in Fig. 15, the current sensor 180a and the current sensor 180b have signal lines 182a and signal lines 182b extending toward the position of arrangement of the driver circuit board 22. The signal lines 182a and the signal lines 182b are joined with a wiring pattern of the driver circuit board 22 by soldering. In this embodiment, the holding member 803, the supporting members 807a to 807b, and the projecting portions 806a to 806b are formed integrally of a resin.

Accordingly, the holding member 803 has a positioning function for the current sensors 180 and the driver circuit board 22, and hence assembly and solder-connecting operation between the signal lines 182a and the driver circuit board 22 is facilitated. Also, by providing the mechanism that holds the current sensors 180 and the driver circuit board 22 on the holding member 803, the number of components as the entire power conversion apparatus may be reduced.

In this embodiment, since the power conversion apparatus 200 is fixed to the housing 10 provided on the transmission TM, the influence of vibrations from the transmission TM is significant. Therefore, the holding member 803 is provided with a supporting member 808 for supporting the vicinity of the center portion of the driver circuit board 22 to reduce the influence of the vibrations applied to the driver circuit board 22. For example, by holding the center portion of the driver circuit board 22 by the supporting member 808, the resonance frequency of the driver circuit board 22 may be set to be higher than the frequency of vibrations transferred from the transmission TM, and the influence of the vibrations of the transmission TM applied to the driver circuit board 22 may be reduced. For reference, the holding member 803 of the bus-bar assembly 800 is fixed to the flow channel forming body 12 by screws.

The holding member 803 is provided with a bracket 809 for fixing one of the end portions of the power module 350 for auxiliary equipment. As illustrated in Fig. 4, the power module 350 for auxiliary equipment is arranged in the cooling portion 407, so that the other end portion of the power module 350 for auxiliary equipment is fixed to the cooling portion 407. Accordingly, the influence of vibrations applied to the power module 350 for auxiliary equipment is reduced and the number of components for fixation may be reduced.

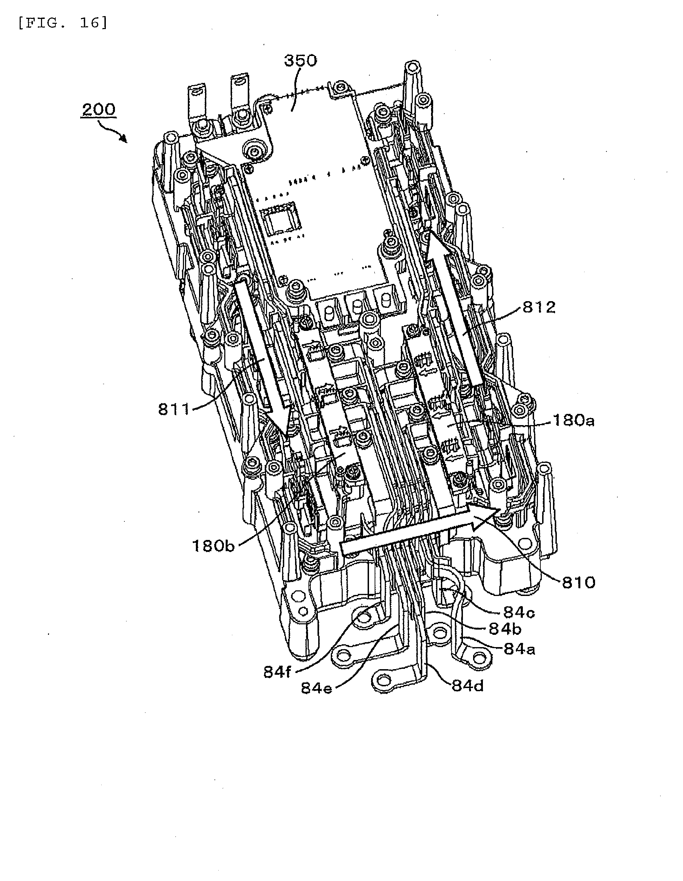

Fig. 16 is an appearance perspective view illustrating a state in which the power semiconductor module, the capacitor module, the bus-bar assembly 800, and the power module 350 for auxiliary equipment are assembled to the flow channel forming body 12. The current sensors 180 may not be used as a sensors at a temperature of approximately 100°C or higher. The environment in which the vehicle-mounted power conversion apparatus is used is quite severe and may be high temperature, so that protecting the current sensors 180 from heat is one of important subjects. In particular, in this embodiment, since the power conversion apparatus 200 is mounted on the transmission TM, protecting the current sensors 180 from the influence of heat generated from the transmission TM is an important subject.

Accordingly, in this embodiment, the current sensor 180a and the current sensor 180b are arranged on the side opposite from the transmission TM by the intermediary of the flow channel forming body 12. Accordingly, the heat generated by the transmission TM can hardly be transferred to the current sensor, and the temperature rise of the current sensor maybe inhibited. Furthermore, the second AC bus-bars 804a to 804f are formed so as to extend across the third flow channel portion 19c shown in Fig. 5. Then, the current sensor 180a and the current sensor 180b are arranged on the side closer to the AC terminal 321 (159) of the power module than portion of the second AC bus-bars 804a to 804f extending across the third flow channel portion 19c. Accordingly, the second AC bus-bars 804a to 804f are cooled indirectly by cooling medium and is capable of alleviating heat transferred from the AC bus-bars to the current sensors, and hence the semiconductor chips in the power modules, so that improvement of reliability is achieved.

A flowing direction 811 illustrated in Fig. 16 indicates a flowing direction of the cooling medium flowing in the fourth flow channel portion 19d illustrated in Fig. 5. In the same manner, a flowing direction 812 indicates a flowing direction of the cooling medium flowing in the second flow channel portion 19b illustrated in Fig. 5. In this embodiment, the current sensor 180a and the current sensor 180b are arranged so that projected portions of the current sensor 180a and the current sensor 180b are surrounded by the projected portion of the cooling medium flow channels 19 when projected from above the power conversion apparatus 200. Accordingly, the current sensor may further be protected from the heat from the transmission TM.

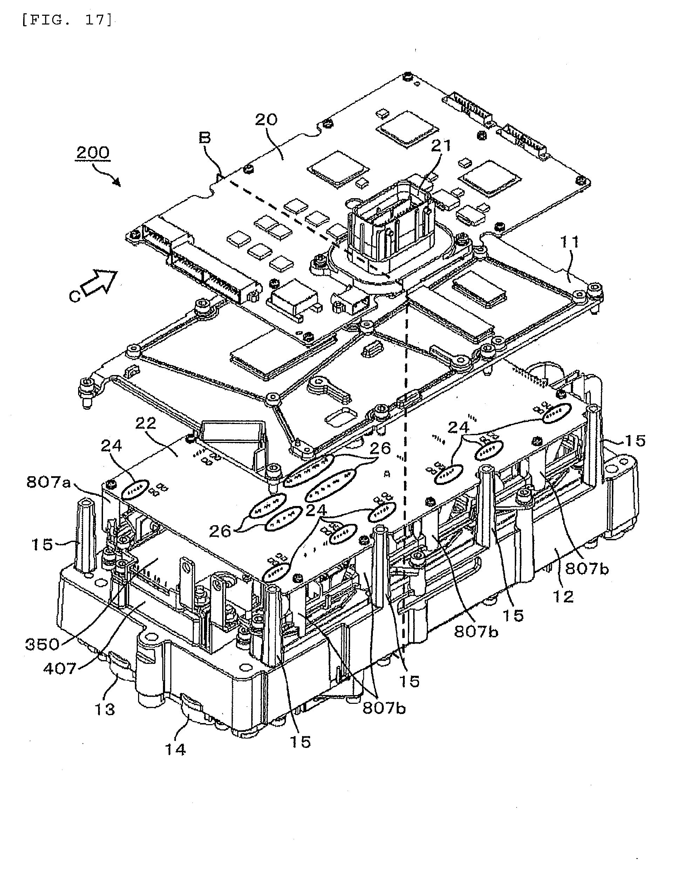

Fig. 17 is a perspective view of a state in which the control circuit board 20 and the metallic base plate 11 are separated for the sake of easy understanding. As illustrated in Fig. 16, the current sensors 180 are arranged above the capacitor module 500. The driver circuit board 22 is arranged above the current sensors 180 illustrated in Fig. 16, and is supported by the supporting members 807a and 807b provided on the bus-bar assembly 800 illustrated in Fig. 14. The metallic base plate 11 is arranged above the driver circuit board 22 and, in this embodiment, is supported by a plurality of supporting members 15 provided so as to extend upright from the flow channel forming body 12. The control circuit board 20 is arranged above the metallic base plate 11 and is fixed to the metallic base plate 11.

Since the current sensors 180, the driver circuit board 22, and the control circuit board 20 are arranged hierarchically in the height direction, and the control circuit board 20 is arranged at a farthest position from the heavy power semiconductor modules 300 and 301, entry of switching noise or the like is inhibited. Furthermore, the metallic base plate 11 is electrically connected to the flow channel forming body 12 electrically connected to the ground. The entry of noise from the driver circuit board 22 to the control circuit board 20 is reduced by the metallic base plate 11.

When using a wiring connector to electrically connecting the current sensors 180 and the driver circuit board 22, it is preferable to avoid complicated connecting steps and connecting failures. In Fig. 17, the driver circuit board 22 is formed with first holes 24 and second holes 26 that penetrate through the driver circuit board 22. The first holes 24 allow insertion of the signal terminals 325U and the signal terminals 325L of the power semiconductor modules 300, and the signal terminals 325U and the signal terminals 325L are joined with the wiring pattern on the driver circuit board 22 by soldering. Furthermore, the signal lines 182 of the current sensors 180 are inserted into the second holes 26, and the signal lines 182 are joined with the wiring pattern on the driver circuit board 22 by soldering. Soldering joint is performed on the side of the surface of the driver circuit board 22 opposite the surface facing the flow channel forming body 12.

Accordingly, the productivity may be improved since the connection of the signal lines are achieved without using the wiring connector. By joining the signal terminals 325 of the power semiconductor modules 300 and the signal lines 182 of the current sensors 180 by soldering from the same direction, further improvement of the productivity is achieved. Furthermore, by providing the first holes 24 that allow the signal terminals 325 to pass through and the second holes 26 that allow the signal lines 182 to pass through respectively on the driver circuit board 22, risk of connection failures may be reduced.

A drive circuit (not shown) for a driver IC chip or the like is mounted on the driver circuit board 22 of this embodiment on the side facing the flow channel forming body 12. Accordingly, transfer of the heat of the soldering joint to the drive IC chip or the like is inhibited, and damage of the driver IC chip or the like by the soldering joint is prevented. Since tall components such as a transmission mounted on the driver circuit board 22 are arranged in a space between the capacitor module 500 and the driver circuit board 22, reduction of the height of the entire power conversion apparatus 200 is enabled.

In this embodiment, the power semiconductor modules 300 and 301 inserted and fixed into the cooling medium flow channels 19 are cooled and the capacitor module 500 is cooled by the cooling medium flowing in the cooling medium flow channels 19. Furthermore, the power module 350 for auxiliary equipment is preferably cooled as well in order to inhibit the temperature rise by heat generation. Since the portion that can be cooled in the housing 10 is limited, a cooling method or a cooling structure need to be devised.

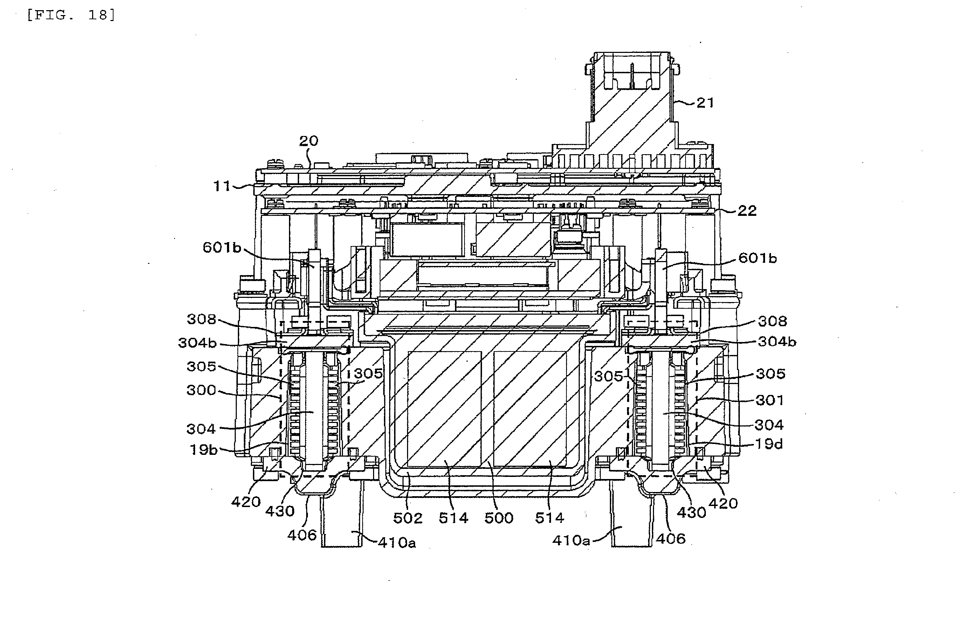

Fig. 18 is a cross-sectional view of the power conversion apparatus 200 taken along a broken line B in Fig. 17 viewed from a direction C. The flange 304B provided on the module case 304 is pressed against an opening of a flow channel of the flow channel forming body 12 and the module case 304 is pressed against the flow channel forming body 12, so that air-tightness of the cooling medium flow channels 19 is improved. In order to improve the cooling efficiency of the power semiconductor modules 300, it is necessary to cause the cooling medium in the cooling medium flow channels 19 to flow to an area where the fins 305 are formed. A lower portion of the module case 304 is not formed with the fins 305 in order to secure the space of the curved portion 304A. Accordingly, the lower cover 420 is formed so that the lower portion of the module case 304 is fitted into a depression 430 formed on the lower cover 420. Accordingly, the cooling medium is prevented from flowing into the space where the cooling fins are not formed.

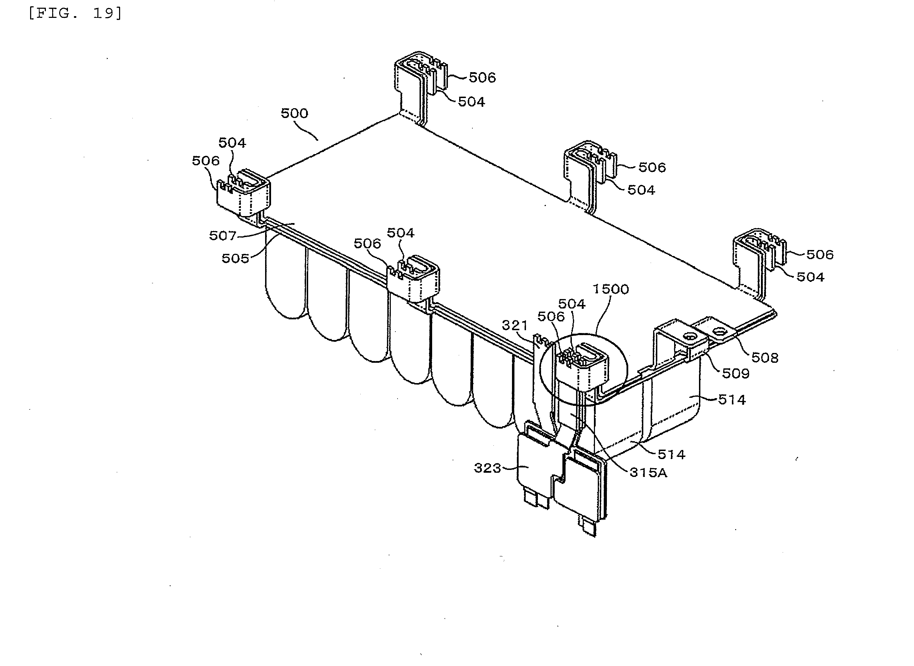

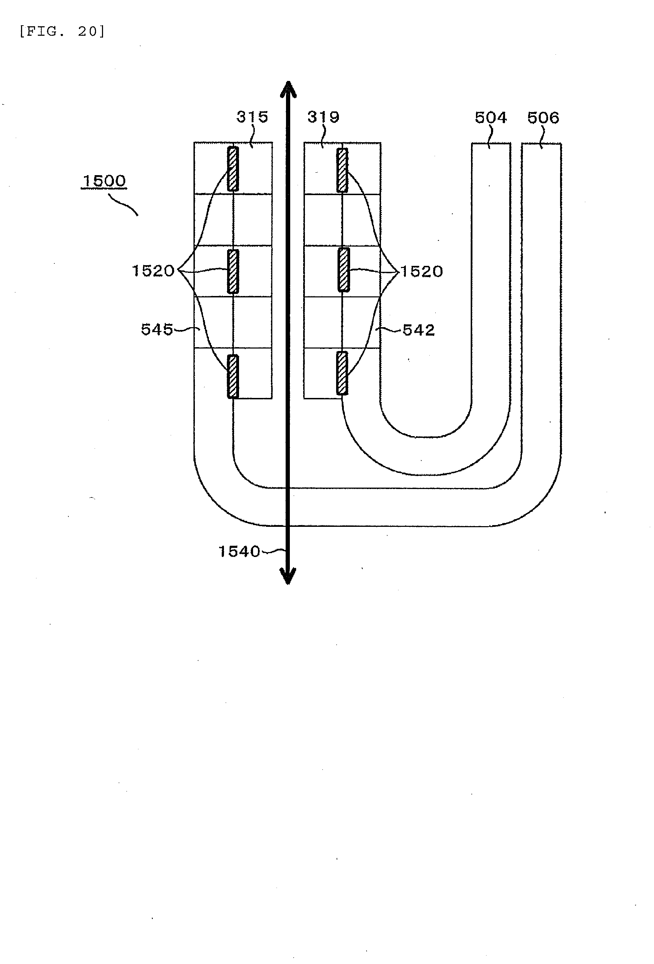

With reference to Fig. 19 and Fig. 20, connecting portions between the positive-side capacitor terminals 506 and the negative-side capacitor terminals 504 on the capacitor module 500 and the DC positive terminal of the power semiconductor module and the DC negative terminal of the power semiconductor module will be described. The connection 1500 indicated by a circle in Fig. 19 is shown in Fig. 20 in an enlargedscale. The positive-side capacitor terminals 506 and the negative-side capacitor terminals 504 are connected to the positive conductive plate 507 and the negative conductive plate 505 which constitute the laminated conductive plate 501 of the capacitor module 500 respectively. The negative-side capacitor terminals 504 and the positive-side capacitor terminals 506 are each formed of a wide conductor, and are arranged in a laminated state so that the wide surfaces of the wide conductors face each other, project from the capacitor module 500, and extend toward the corresponding power semiconductor module. In other words, the negative-side capacitor terminals 504 and the positive-side capacitor terminals 506 rise in the direction opposite from the cooling medium flow channels respectively, and then extend along the cooling medium flow channels.

The connecting portions 545 of the positive-side capacitor terminals 506 are positioned at distal end portions of the positive-side capacitor terminals 506, the connecting portions 545 of the positive-side capacitor terminals 506 get close from the direction along the the cooling medium flow channel to the DC positive terminal of the power semiconductor module extending in the direction across the flow of the cooling medium and wide surfaces are in contact with each other. In the same manner, the negative-side capacitor terminals 504 have the connecting portions 542 at distal end portions thereof, the connecting portions 542 of the negative-side capacitor terminals 504 get close from the direction along the the cooling medium flow channel to the DC negative terminal 319 of the power semiconductor module extending in the direction across the flow of the cooling medium and wide surfaces are in contact with each other.

As illustrated in Fig. 20, this structure is such that the positive-side capacitor terminals 506 and the negative-side capacitor terminals 504 rise in the direction away from the cooling medium flow channel in a laminated state and then return back in the direction along the flow channels, and hold the DC terminal in the laminated state including the DC positive terminal 315 of the power semiconductor module and the DC negative terminal 319 of the power semiconductor module from both sides. In this configuration, the positive-side capacitor terminals 506 and the negative-side capacitor terminals 504 can get close and hence the reduction of inductance is achieved. Also, the DC positive terminal 315 of the power semiconductor module and the DC negative terminal 319 of the power semiconductor module can get close and hence the reduction of inductance is achieved.

In Fig. 20, welded joint portions 1520 are arranged on the side opposite the cooling medium flow channel. Therefore, since the electrode for welding can be inserted from the side opposite the cooling medium flowing channel, welding can be performed easily, which leads to improvement of the productivity or improvement of reliability of welded portions.

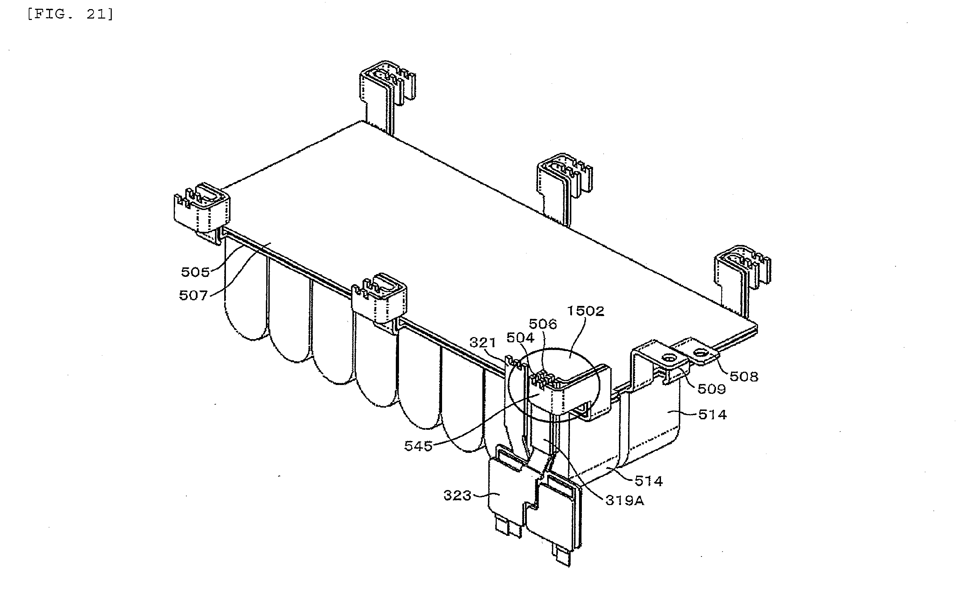

Fig. 21 is a drawing for explaining another embodiment 1502 of the structure 1500 of the connecting portion described in conjunction with Fig. 19 or Fig. 20. The difference from the structure of the connecting portions described in Fig. 19 and Fig. 20 is that the laminated terminal including the positive-side capacitor terminals 506 and the negative-side capacitor terminals 504 rise once, and changes the direction of extension, for example, to the vertical direction along the outer periphery of the capacitor module 500 instead of returning back, extend toward the DC terminal of the power semiconductor module along the cooling medium flow channel, and then is connected. The effect is substantially the same as the structure in Fig. 20.

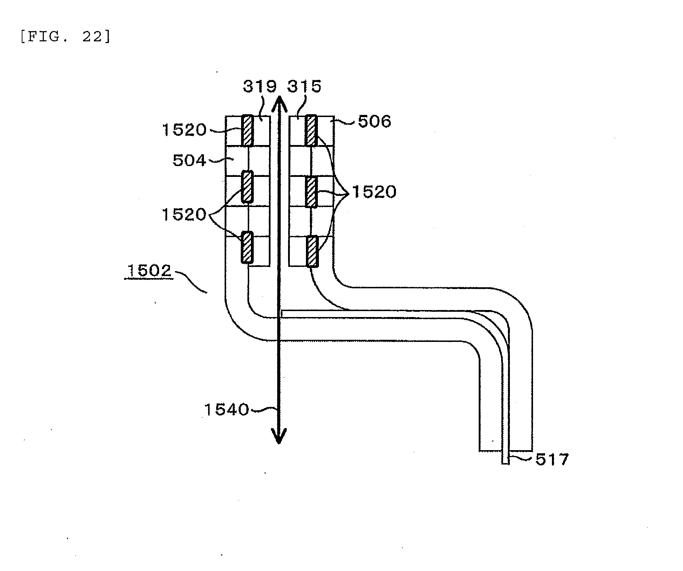

Fig. 22 is a drawing showing still another embodiment, the positive-side capacitor terminals 506 and the negative-side capacitor terminals 504 in the laminated structure rising from the laminated conductive plate 501 of the capacitor module 500 change the direction and extend toward the cooling medium flow channel for cooling the power semiconductor modules 300, change the direction and extend toward a direction 1540 along the cooling medium flow channels at positions of the power semiconductor module inserted into the cooling medium flow channel, and are connected to the DC positive terminal 315 of the power semiconductor module and the DC negative terminal 319 of the power semiconductor module. The welded joint portion 1520 is at a position opposite the cooling medium flow channel, so that the welding work is easily performed.

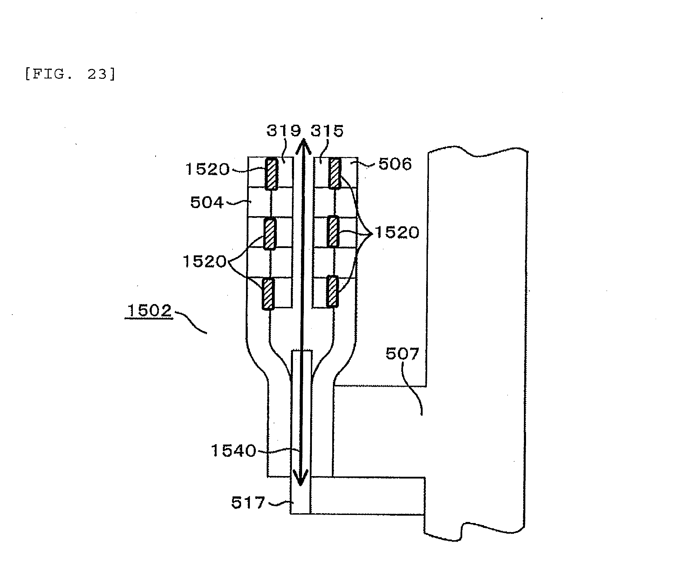

Fig. 23 is a drawing showing another embodiment of the connecting structure among the positive-side capacitor terminals 506 or the negative-side capacitor terminals 504 of the capacitor module, the DC positive terminal 135 of the power semiconductor module and the DC negative terminal 319 of the power semiconductor module. The DC terminal extends from the positive conductive plate 507 and the negative conductive plate 505 (not illustrated in Fig. 23) toward the cooling medium flow channel, and then rises in the direction opposite from the cooling medium flow channel, then extends in the direction 1540 along the cooling medium flow channel, and comes into contact with the wide surfaces of the DC positive terminal 315 of the power semiconductor module and the DC negative terminal 319 of the power semiconductor module and is connected by welding. The welded joint portions 1520 is at a position opposite from the cooling medium flow channel, so that the welding work is easily performed as described above.

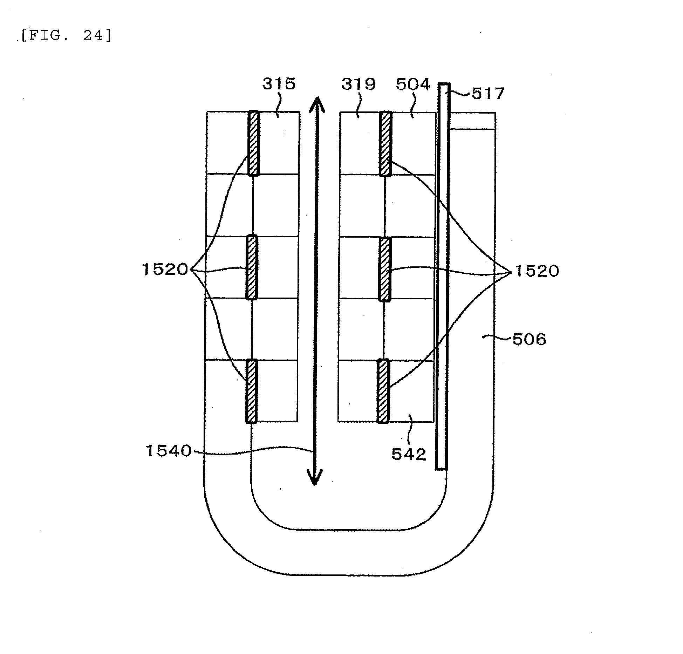

Fig. 24 is a drawing showing another embodiment of the connecting structure among the positive-side capacitor terminals 506 or the negative-side capacitor terminals 504 of the capacitor module, and the DC positive terminal 315 of the power semiconductor module and the DC negative terminal 319 of the power semiconductor module. The configuration is such that the positive-side capacitor terminals 506 surrounds the connecting portion between the negative-side capacitor terminals 504 and the DC negative terminal 319 of the power semiconductor module, and the welded joint portions 1520 are located in the direction opposite from the cooling medium flow channel in the same manner as other embodiments. As described above, in this configuration, the welding work is easily performed. The above-described structure allows the negative-side capacitor terminals 504 and the positive-side capacitor terminals 506 to be arranged close to each other via the insulative sheet 517. Since the DC positive terminal 315 of the power semiconductor module and the DC negative terminal 319 of the power semiconductor module may be arranged close to each other, reduction of the inductance of the connecting portion between the DC terminal of the power semiconductor module and the DC terminal of the capacitor module 500 is achieved.

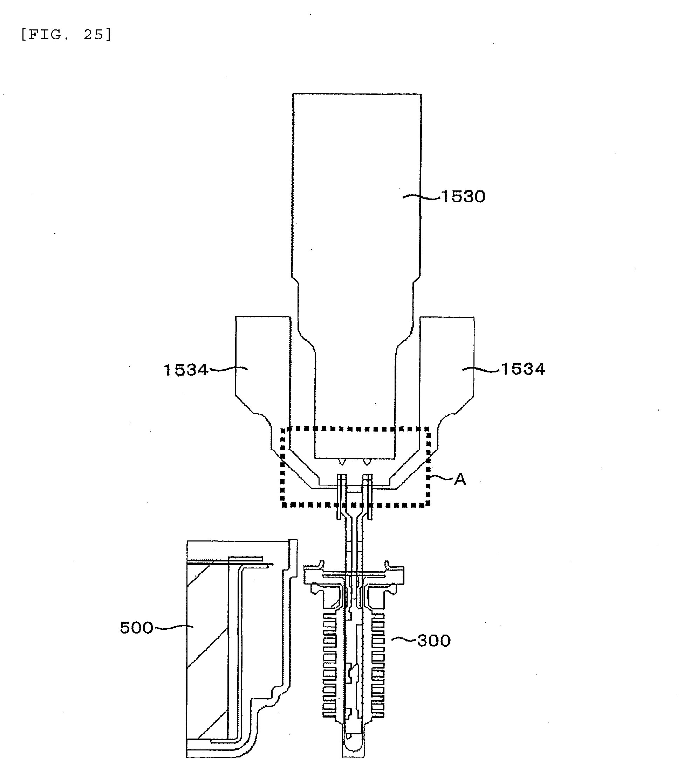

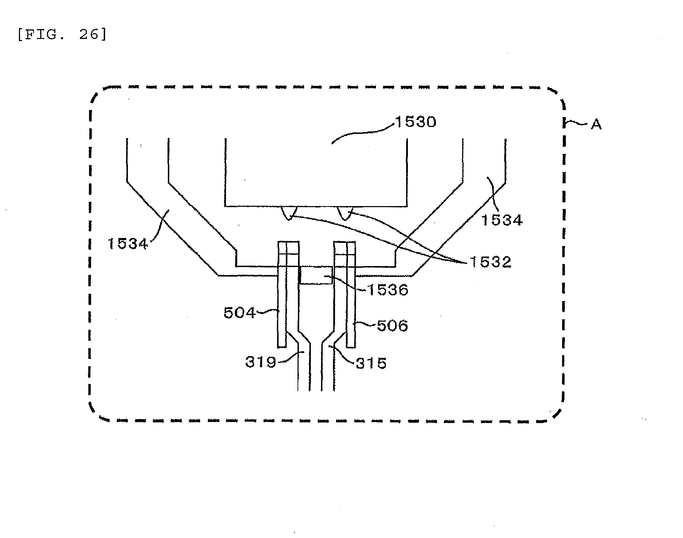

Fig. 25 and Fig. 26 are explanatory drawings for explaining the welding work between the DC terminal of the power semiconductor module and the DC terminal of the capacitor module 500 illustrated from Fig. 19 to Fig. 24. The welding work is the same for the power semiconductor module 300 and for the power semiconductor module 301, and hence the welding work of the power semiconductor module 300 will be described as a representative. The capacitor module 500 and the power semiconductor modules 300 are held by the flow channel forming body 12 as described above, and the connecting portion between the DC terminal of the power semiconductor module and the DC terminal of the capacitor module 500 is located in the direction opposite from the cooling medium flow channel where the power semiconductor module 300 is inserted, that is, on the lid side of the housing 10. An enlarged view of a portion of a broken line A in Fig. 25 corresponds to Fig. 26. The DC positive terminal 315 of the power semiconductor module 300 and the DC negative terminal 319 of the power semiconductor module are configured of a wide conductor, and are arranged to form a laminated structure with the wide surfaces faced each other. The positive-side capacitor terminals 506 and the negative-side capacitor terminals 504 are arranged outside of the respective terminals and are arranged so that the wide surfaces come into contact with each other. A guide 1536 is arranged between the positive-side capacitor terminals 506 and the negative-side capacitor terminals 504, the positive-side capacitor terminals 506 and the DC positive terminal 315 of the power semiconductor module, and the negative-side capacitor terminals 504 and the DC negative terminal 319 of the power semiconductor module are held and fixed between guides 1534 located on both sides and the guide 1536 located at the center, and then the respective connecting surfaces are welded by an electrode 1532 of a welder 1530.

As described above, since the connecting portions between the DC terminal of the power semiconductor module and the terminal of the power semiconductor module are located in the direction opposite from the cooling medium flow channel or the flow channel forming body 12, the welding work is performed easily and improvement of the productivity is achieved. In the same manner, since the connecting portion between the bus-bar assembly and the power semiconductor module is located in the direction opposite from the cooling medium flow channel or the flow channel forming body 12, the welding work is performed easily and improvement of the productivity is achieved.

In the description given above, various embodiments and modifications have been described. However, the present invention is not limited thereto. Other modes conceivable within a range of a technical idea of the present invention are included within the scope of the invention.

The disclosure of the following priority basic application is incorporated herein by reference. Japanese Patent Application No. 2010-84785 (filed on April 1st, 2010).

## Claims

1. A power conversion apparatus comprising:
a smoothing capacitor module having a plurality of one and the other DC terminals arranged in a state of being laminated with each other;
a flow channel forming body for forming a cooling medium flow channel that allows a cooling medium to flow along the capacitor module; and
a plurality of power semiconductor modules each including a module case having a cooling surface, DC terminals projecting in one direction in a laminated state from the module case, and an AC terminal projecting in one direction from the module case, **characterized in that** the power semiconductor modules are fixed to the flow channel forming body so that the cooling surface of the module case of the power semiconductor module is inserted into the cooling medium flow channel of the flow channel forming body and comes into contact with the cooling medium flowing within the flow channel forming body, and
the respective DC terminals in the laminated state of the capacitor module extend from the capacitor module toward the corresponding power semiconductor modules, the laminated DC terminal includes a connecting portion in the direction along the flow channel, the respective connecting portions in the direction along the flow channels of the DC terminals of the capacitor module are respectively connected to the DC terminals projecting from the power semiconductor module in the direction across the cooling medium flow channel.

2. The power conversion apparatus according to Claim 1, **characterized in that** the respective DC terminals in the laminated state of the capacitor module are respectively formed of wide conductors, and the DC terminals in the laminated state projecting from the module case of the power semiconductor modules are formed of wide conductors project from the module case in the direction opposite the cooling medium flow channel,
wide surfaces of the wide conductors of the respective DC terminals of the capacitor module come into contact respectively with wide surfaces of the DC terminals formed of the wide conductors of the power semiconductor module, and
the respective DC terminals of the capacitor module being in contact with each other over the wide surfaces and the DC terminals of the power semiconductor modules are connected at portions in the direction opposite the cooling medium flow channel by welding.

3. The power conversion apparatus according to Claim 1 or Claim 2, **characterized in that** the DC terminals in the laminated state projecting from the module cases of the power semiconductor modules in the one direction which is a direction opposite the cooling medium flow channel are respectively formed of wide conductors that the wide surfaces face each other, and
the respective connecting portions of the capacitor module are formed of wide conductors so that the wide surfaces face each other, the wide surfaces located respectively inside the connecting portions of the capacitor module in the laminated state are fixed by welding so as to come into contact with the wide surfaces located outside the respective DC terminals of the power semiconductor modules in the laminated state.

4. The power conversion apparatus according to Claim 3, **characterized in that** the capacitor module includes a capacitor case and a plurality of capacitor cells stored in the capacitor case, and the DC terminals of the capacitor module project from the capacitor case in the laminated state, and
the DC terminals of the capacitor module has a shape in which at least one of the DC terminals returns back in the direction of flow of the cooling medium in a segment between a connecting portion with respect to the DC terminal of the power semiconductor module and the capacitor case and a connecting portion of the other DC terminal of the capacitor module is located inside the returning back shape of the one of the DC terminals.

5. The power conversion apparatus according to Claim 4, **characterized in that** the DC terminals of the capacitor module has a shape in which the DC terminals respectively return back in the direction of flow of the cooling medium in a segment between a connecting portion with respect to the DC terminal of the power semiconductor module and the capacitor case and a connecting portion of the other DC terminal of the capacitor module is located inside the returning back shape of the one of the DC terminals.

6. The power conversion apparatus according to one of Claim 1 to 5, **characterized in that** the power semiconductor modules each include semiconductor chips configuring an upper and lower arms, and a conductor configured to connect the semiconductor chips of the upper arm and the lower arm in series, and
the AC terminals of the respective power semiconductor modules are electrically connected to the conductor configured to connect the semiconductor chips of the upper arm and the lower arm in series in the interiors of the respective power semiconductor modules.

7. The power conversion apparatus according to Claim 6, **characterized in that** an AC bus-bar assembly provided with a plurality of AC bus-bars are arranged with respect to the capacitor module via a space, and the AC bus-bars are connected by welding to the AC terminals of the corresponding power semiconductor modules.

8. The power conversion apparatus according to Claim 7, **characterized in that** a driver circuit configured to operate the respective power semiconductor modules is arranged at a position opposite the capacitor module with the AC bus-bar assembly interposed therebetween.

9. The power conversion apparatus according to one of Claim 6 to 8, **characterized in that** the capacitor module has a substantially rectangular shape, and a plurality of DC terminals in the laminated state are arranged along a long side of the capacitor module, and a power supply terminal configured to transfer DC power with the DC power supply is provided on a short side of the capacitor module.
